# EUROPEAN PATENT APPLICATION

(11) **EP 2 268 119 A1**
(43) Date of publication of application: **29.12.2010**
(21) Application number: 09724621.9
(22) Date of filing: 25.03.2009
(51) Int. Cl.: H05K 9/00, G02F 1/1335, G09F 9/00, G02B 1/10, G02B 1/11, G02B 5/22, H01J 11/02

(54) **OPTICAL FILTER FOR DISPLAY, METHOD FOR MANUFACTURING THE SAME, AND DISPLAY AND PLASMA DISPLAY PANEL EQUIPPED WITH OPTICAL FILTER FOR DISPLAY**

(30) Priority: 27.03.2008 JP 2008083039
(71) Applicant: Bridgestone Corporation, Tokyo 104-0031 (JP)
(72) Inventor: AOKI, Shigeru, Yokohama-shi Kanagawa 244-8510 (JP)
(74) Representative: Oxley, Robin John George
(86) International application number: PCT/JP2009/055966
(87) International publication number: WO 2009/119674

(57) **Abstract**

[Problem to be solved]

To provide an optical filter for display provided with an earth electrode which can be easily prepared, and a process for the preparation thereof.

[Means for solving problem]

An optical filter for display provided with an electrode part of a conductive metal layer comprising a transparent substrate, the conductive metal layer provided on a surface of the substrate, and a functional layer provided on a surface of the conductive layer, wherein the conductive metal layer is exposed in a large number of island-shaped areas at a side edge or its vicinity of the functional layer, and the number of the island-shaped areas is 25 to 250/cm² in an intermittent band-shaped region and an area ratio of the island-shaped areas is 2 to 50% based on the intermittent band-shaped region, the intermittent band-shaped region being defined by a band-shaped area having a perpendicular width between the most inside point and the most outside point of the island-shaped areas, and a process for the preparation thereof.

## Description

### Field of the invention

The present invention relates to an optical filter for adding various functions such as antireflection, near-infrared shielding and electromagnetic wave shielding to various displays such as plasma display panel (PDP), cathode-ray-tube (CRT) display, liquid crystal display, organic EL (electroluminescence) display and field emission display (FED) including surface-conduction electron-emitter display (SED), and a display, particularly PDP, provided with the optical filter.

### Description of the Related Art

In flat-panel displays such as liquid crystal display, plasma display panel (PDP) and organic EL display, and CRT display, the problem that external light is reflected on a surface of the display to have difficulty seeing visual information of the display has been known. Therefore, various countermeasures including provision of various optical films such as an antireflection film on the displays are taken.
In recent years, image magnification has entered the mainstream of the displays, and use of PDP as a next-generation image magnification display have been generalized. However, high-frequency pulse discharge is carried out in the light emitting part of the PDP for image display, and therefore unnecessary electromagnetic waves or infrared rays causing malfunction of infrared remote control are possibly radiated. Thus, as for the PDP, various antireflection films (electromagnetic-wave shielding and light transmitting plates) having electric conductivity for PDP are proposed. Examples of the electromagnetic-wave shielding and light transmitting plates include (1) a transparent substrate having a metallic silver-containing transparent conductive thin layer thereon; (2) a transparent substrate having a conductive mesh layer consisting of network-patterned metallic wire or conductive fiber thereon; (3) a transparent substrate having network-patterned copper foil layer obtained by etching-processing copper foil so as to have opening parts thereon; (4) a transparent substrate having mesh-shaped conductive ink formed by printing thereon.
Further, onto conventional large-size displays including PDP, various optical films such as an antireflection film and a near-infrared cut film in addition to the above-mentioned conductive layer are attached. For example, Patent Document 1 describes an optical filter comprising at least a first film having an antireflection layer and anti-glare layer thereon and a second film having an electromagnetic-wave shielding layer, the first film being provided on the side having the electromagnetic-wave shielding layer, the second film being larger than the first film, and a side edge portion of the electromagnetic-wave shielding layer being exposed.
In the optical filter, it is required to ground (earth) the conductive layer (electromagnetic-wave shielding material) such as a conductive mesh layer to a body of PDP in order to enhance electromagnetic-wave shielding property of the conductive layer. Therefore, the optical filter of the Patent Document 1 proposes a cumbersome method that the film having an electromagnetic-wave shielding layer (conductive layer) is prepared so as to have larger size than that of a film having other functional layer and these films are aligned and combined whereby a side edge portion of the electromagnetic-wave shielding layer is exposed.
As methods for easily exposing the conductive mesh, Patent Documents 2 and 3 propose a method that a side edge of a functional layer or film on the conductive mesh is irradiated with a laser, the irradiated functional layer or film is removed to expose the conductive mesh and the exposed area is used as electrode part for earth.
List of Patent documents:
Patent Document 1: JP2003-66854 A
Patent Document 2: JP2004-327720 A
Patent Document 3: JP2007-243158 A

### Disclosure of the Invention

### Problem to be solved by the Invention

In the optical filter described in Patent Document 1, in order to expose a side edge portion of the electromagnetic-wave shielding layer , the film having an electromagnetic-wave shielding layer (conductive layer) is prepared so as to have larger size than that of a film having other functional layer and these films are accurately aligned and combined to expose the side edge portion of the electromagnetic-wave shielding layer, and therefore, cumbersome procedures are required.
On the other hand, in case an optical filter for display such as PDP is prepared using a continuous plastic film, a near-infrared cut film and an antireflection film are prepared respectively, these films are laminated through a conductive mesh layer for electromagnetic-wave shielding to prepare a continuous optical filter and then cutting it in accordance with the shape of the front surface of the display. Therefore the continuous optical filter is generally cut in the width direction. In the side cut in the width direction, i.e., the cut surface (side), all the layers are exposed, but the exposed portion of the cut sides have only extremely small areas. The conductive layer (e.g., conductive mesh) also have only extremely small exposed edge side (area). If it is possible to use the optical filter as mentioned above as it is, and to ground (earth) the filter by means of the exposed conductive layer (e.g., conductive mesh) to a body of PDP in order to render the electromagnetic-wave shielding property excellent, an easily-groundable optical filter for display can be obtained in high productivity.
Hence, it is advantageous to use the method described in Patent Documents 2 and 3, wherein a side edge of a functional layer or film on the conductive mesh is irradiated with a laser, and the irradiated functional layer or film is removed to expose the conductive mesh. However, in case the functional layer or film is removed by the irradiation of a laser, the conductive mesh provided on the substrate per se is occasionally peeled from the substrate.
Thus, the object of the present invention is to provide an optical filter for display which has excellent electromagnetic-wave shielding property and earth electrode that can be easily grounded, and which can be easily prepared.
Further, the object of the present invention is to provide an optical filter for display which has excellent electromagnetic-wave shielding property and earth electrode that can be easily grounded, which can be easily attached to a display, and which can be easily prepared.
Furthermore, the object of the present invention is to provide a process for the preparation of an optical filter for display which has excellent electromagnetic-wave shielding property and earth electrode that can be easily grounded, and by which the optical filter can be easily obtained.
Still, the object of the present invention is to provide a display in which the optical filter having excellent characteristics is attached onto a surface of a glass plate for image display of the display.

### Means for solving problem

Thus, the present invention can be provided by an optical filter for display provided with an electrode part comprising a transparent substrate, a conductive metal layer provided on a surface of the transparent substrate, and a functional layer provided on a surface of the conductive metal layer, the electrode part consisting of a conductive (electrically-conductive) metal layer,
wherein the conductive metal layer is exposed in a large number of island-shaped areas at a side edge of the functional layer or in a vicinity of the side area, and
the number of the island-shaped areas is 25 to 250/cm² in an intermittent band-shaped region and an area ratio of the island-shaped areas is 2 to 50% (preferably 15 to 50%) based on the intermittent band-shaped region, the intermittent band-shaped region being defined by a band-shaped area having a perpendicular width between the most inside point and the most outside point of the island-shaped areas.
In detail, the above-mentioned wording "perpendicular width" means one of sides of a rectangular triangle formed by the most inside point and the most outside point of the island-shaped areas and a diagonal therebetween, the one side of rectangular triangle being perpendicularly to a side edge of the transparent substrate.
The preferred embodiments of the optical filter for display according to the present invention are described as follows:
(1) The intermittent band-shaped region consists of plural rows, each of the rows being formed from a large number of island-shaped areas arranged in a line, whereby the effect suppressing the peel failure of a conductive layer caused by heat is enhanced and it is easier to ground the optical filter as well.
(2) The island-shaped areas in two adjacent rows of the intermittent band-shaped region are arranged so as to have deviation from the band direction between the two rows (so-called, zigzag alignment). Thereby the effect suppressing the peel failure of a conductive layer caused by heat is enhanced and it is easier to ground the optical filter as well.
(3) The conductive metal layer is a mesh-shaped conductive metal layer.
(4) The functional layer is a hard coat layer. The hard coat layer as the functional layer is a cross-linked body having good heat stability compared with the transparent substrate, and therefore it is preferred to use a laser having a wavelength in ultraviolet ray (UV) region in order to remove the hard coat layer with the mesh-shaped conductive layer being prevented from peeling from the substrate. However, an existing UV laser has low pulse energy compared with an infrared (IR) laser and is expensive, and hence it is advantageous and preferable to use the IR laser having high pulse energy and low cost whereby the optical filter of the present invention can be prepared at low cost and in high productivity.
   The IR laser is classified roughly into one having wavelength of approx. 1µm and one having wavelength of approx. 10µm. The IR laser having wavelength of approx. 1µm shows low absorption (high transparency) into the functional layer such as a hard coat layer and the transparent substrate whereas it shows high absorption and reflectance into the conductive metal layer. Therefore it is difficult that the IR laser having wavelength of approx. 1µm effectively removes only the functional layer from the substrate without peeling the conductive metal layer from the substrate. On the other hand, the IR laser having wavelength of approx. 10µm (especially 5 to 15µm) is scarcely absorbed into the conductive metal layer and shows high absorption into the functional layer such as a hard coat layer and the transparent substrate. Therefore the IR laser enables only the functional layer to remove effectively from the substrate without peeling the conductive metal layer from the substrate. Thus this IR laser is especially suitable for the process of the present invention.
(5) The functional layer comprises a hard coat layer and a low refractive index layer having refractivity lower than that of the hard coat layer, the hard coat layer being in contact with the conductive metal layer. Thereby excellent antireflection properties can be obtained.
(6) The functional layer comprises a hard coat layer, a high refractive index layer having refractivity higher than that of the hard coat layer and a low refractive index layer having refractivity lower than that of the hard coat layer, the hard coat layer being in contact with the conductive metal layer. Thereby more excellent antireflection properties can be obtained.
(7) The functional layer is an anti-glare layer, which generally shows excellent antireflection effect, and therefore the provision of the anti-glare layer often brings about no provision of the antireflection layer mentioned in the above (5) and (6). The provision of the anti-glare layer enhances freedom degree with respect to selection of refractive index of other layers to broaden the options of materials of the layers, whereby reduction of cost can be also obtained.
(8) The functional layer comprises an anti-glare layer and a low refractive index layer having refractivity lower than that of the anti-glare layer, the anti-glare layer being in contact with the conductive metal layer. Thereby excellent antireflection properties can be obtained compared with the provision of only the anti-glare layer.
(9) Other functional layer(s) (preferably near-infrared absorption layer) is provided on a side having no conductive metal layer of the transparent substrate.
(10) The other functional layer(s) is at least one layer selected from a near-infrared absorption layer, a neon-cut layer and a transparent adhesive layer. It is preferred that a second functional layer is a transparent adhesive layer having near-infrared absorption function and neon-cut function; or that the second functional layer comprises a near-infrared absorption layer having neon-cut function and a transparent adhesive layer, superposed in this order on the transparent substrate; or that the second functional layer comprises a near-infrared absorption layer, a neon-cut layer and a transparent adhesive layer, superposed in this order on the transparent substrate.
(11) The transparent substrate is a plastic film.
(12) A release sheet is provided on the transparent adhesive layer. It becomes easy to attach the optical filter onto a display.
(13) The optical filter for display is attached to a glass plate.
(14) The optical filter for display is an optical filter for plasma display panel.

Further, the present invention is provided by a process for the preparation of an optical filter for display provided with an electrode part consisting of a conductive metal layer,
which comprises a step of intermittently irradiating with a laser a side edge of a functional layer of a laminate or in a vicinity of the side area to remove the irradiated areas of the functional layer whereby the conductive metal layer is exposed in a large number of island-shaped areas, the laminate comprising a transparent substrate, the conductive metal layer provided on a whole surface of the substrate, and the functional layer provided on a whole surface of the conductive layer,
the number of the island-shaped areas being 25 to 250 /cm² in an intermittent band-shaped region, an area ratio of the island-shaped areas being 2 to 50% (preferably 15 to 50%) based on the intermittent band-shaped region, and the intermittent band-shaped region being defined by a band-shaped area having a perpendicular width between the most inside point and the most outside point of the island-shaped areas.
The embodiments of the process for the preparation of optical filter for display according to the present invention are described as follows:
(1) A diameter of focused beam of the laser irradiating the functional layer is 0.4 to 1.0mm.
(2) A wavelength of the laser is 0.2 to 30µm, especially 5 to 15µm.
(3) The laser is a pulse laser.
(4) A group of island-shaped conductive metal layer areas (corresponding to a row) is arranged in plural lines along the side edge. Thereby, the effect suppressing the peel failure of a conductive layer caused by heat is enhanced and it is easier to ground the optical filter as well.
(5) In the plural rows of island-shaped conductive metal layer areas, the island-shaped areas of the adjacent rows (of the intermittent band-shaped region) are formed so as to be arranged with deviation from the band direction between the adjacent rows (i.e., zigzag alignment). Thereby the effect suppressing the peel failure of a conductive layer caused by heat is enhanced and it is easier to ground the optical filter as well.
(6) In case the optical filter of the invention is continuously prepared from a continuous laminate, the preparation is carried out by the following steps: a first step of running the continuous laminate between two rolls by use of a device for running it by driving force (a so-called roll-to-roll device) and setting a laser head to a predetermined position in the vicinity of the side edge of the continuous laminate under running, and then carrying out a processing for deleting continuously and simultaneously the functional layer in plural rows; and a second step of intermittently running the continuous laminate by use of the roll-to-roll device, and scanning the laser in the direction perpendicular to the running direction when the continuous laminate is stopped whereby the functional layer is simultaneously deleted in plural rows, thus the continuous laminate being cut to give a resultant rectangular laminate having a group of island-shaped conductive metal layer areas in its complete periphery.
(7) The irradiation of the laser to the functional layer is carried out (scanned) so as to describe rectangle. The used rectangular laminate may be obtained by cutting the continuous laminate in the form of rectangle having the predetermined size.

Furthermore, the present invention is provided by a display provided with the optical filter for display as defined above (generally by attaching the optical filter for display to a surface for image display of a glass plate); and
a plasma display panel provided with the optical filter for display as defined above (generally by attaching the optical filter for display to a surface for image display of a glass plate).
The optical filter for display is preferably attached to a glass plate such that the surface (side) having no conductive layer of the optical filter is in contact with a surface for image display of a glass plate.

### Effect of the Invention

In the process for the preparation of an optical filter for display of the present invention, a side edge of a functional layer of a laminate or in a vicinity of the side edge is intermittently irradiated with a laser to remove the irradiated areas of the functional layer with suppressing peeling of the conductive metal layer from the substrate, whereby the conductive metal layer as electrode part is exposed, the laminate comprising a transparent substrate, the conductive metal layer provided on a whole surface of the substrate, and the functional layer provided on a whole surface of the conductive layer, and the above laser radiation is carried out such that the density (number) of the island-shaped areas and the area ratio of the island-shaped areas are in the predetermined ranges. Hence, an optical filter having electrode part (earth electrode) of conductive metal layer in its periphery can be extremely easily obtained, and simultaneously the optical filter is free of defect as well because peeling of the conductive metal layer is prevented in formation of the electrode part. Especially, in case the first functional layer is a thin film such as a hard coat layer, heat of laser is apt to influence an adhesion surface between the conductive metal layer and transparent substrate (generally the adhesion surface has an adhesion layer). In order to suppress the influence of the heat as above, the process of the present invention is especially effective. The resultant electrode part is a conductive metal layer area clearly exposed in the periphery of the optical filter, and therefore the optical filter is easily grounded by the electrode part.
Thus the optical filter of the invention provided with island-shaped conductive metal layer areas (electrode part) having the specific density (number) and the specific area ratio of the island-shaped areas has electrode part (earth electrode) that can be easily grounded, and simultaneously is almost free of defect, and further has excellent productivity.
Particularly, in case of using one transparent substrate to prepare an optical filter, the resultant optical filter has an extremely small thickness and its weight is also decreased with the reduction of thickness. Therefore the optical filter can be easily handled during and after attachment of the filter onto the display.
Thus the optical filter for display of the invention is capable of adding various functions such as antireflection, near-infrared shielding and electromagnetic wave shielding to various displays such as plasma display panel (PDP), cathode-ray-tube (CRT) display, liquid crystal display, organic EL (electroluminescence) display, field emission display (FED) including surface-conduction electron-emitter display (SED), and shows high productivity.

### Brief Description of the Drawings

[Fig. 1] Fig. 1 is a view for explaining an example of the process for the preparation of the optical filter for display provided with electrode part according to the present invention.
[Fig. 2] Fig. 2 is a plain view of an example of the optical filter for display provided with electrode part obtained by the process shown in Fig. 1.
[Fig. 3] Fig. 3 is a plain view of another example of the optical filter for display provided with electrode part obtained by the process shown in Fig. 1.
[Fig. 4] Fig. 4 is a schematic section view of a typical example of the optical filter for display provided with electrode part obtained by the process shown in Fig. 1.
[Fig. 5] Fig. 5 is a schematic plain view of one example of an exposed area of conductive metal layer of the optical filter for display provided with electrode part obtained by the process shown in Fig. 1.
[Fig. 6] Fig. 6 is a schematic section view of one example of preferred embodiments of the optical filter for display provided with electrode part obtained by the process shown in Fig. 1.
[Fig. 7] Fig. 7 is a view for explaining an example of other embodiments of the process for the preparation of the optical filter for display provided with electrode part according to the present invention.
[Fig. 8] Fig. 8 is a plain view of an example of the optical filter for display provided with electrode part obtained by the process shown in Fig. 7.
[Fig. 9] Fig. 9 is a schematic plain view of another example of an exposed area of conductive metal layer of the optical filter for display provided with electrode part obtained by the process shown in Fig. 7.
[Fig. 10] Fig. 10 is a schematic section view of a preferred example of the optical filter for display provided with electrode part obtained by the process shown in Fig. 7.
[Fig. 11] Fig. 11 is a schematic section view of a preferable example of other embodiments of the optical filter for display provided with electrode part obtained by the process shown in Fig. 7.
[Fig. 12] Fig. 12 is a schematic section view showing an example of the condition that the optical filter is attached onto an image display surface of a plasma display panel.

### Explanation of reference number

- 12, 22, 32, 42: Transparent substrate
- 13, 23, 33, 43: Conductive metal layer
- 13', 23', 33', 43': Exposed area of conductive metal layer
- 13", 33": Island-shaped area
- 16, 26, 36, 46: Hard coat layer
- 16', 26': Edge-area hard coat layer
- 24, 47: Low refractive index layer
- 27': Edge-area low refractive index layer
- 14, 24, 34, 44: Near-infrared absorption layer
- 15, 25, 35, 45: Transparent adhesive layer

### Description of Preferred Embodiments

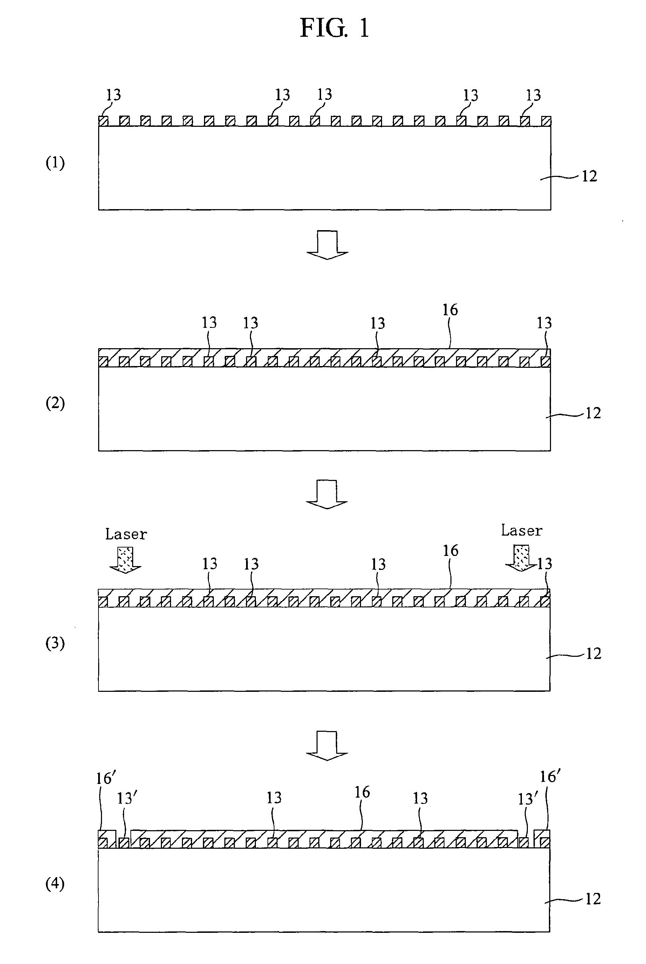

The process for the preparation of an optical filter for display provided with an electrode part (ground electrode) according to the present invention, and the optical filter for display provided with an electrode part are explained in detail below.
A schematic section view for explaining an example of the process for the preparation of the optical filter for display provided with electrode part according to the present invention is shown in Fig. 1.
A mesh-shaped conductive metal layer 13 is formed on a whole surface of a continuous transparent substrate 12 (step 1), and subsequently a hard coat layer 16 comprising synthetic resin as a functional layer is formed on a whole surface of the mesh-shaped conductive metal layer 13 (step 2). For example, the continuous laminate as prepared above is wound in the form of roll, the continuous laminate is continuously fed from the roll by means of, for example, roll-to-roll system, and the side edge of the hard coat layer 16 is intermittently irradiated with a laser (step 3). Both the side edges may be simultaneously irradiated, or one side edge may be irradiated and thereafter another side edge may be done. The irradiation of laser is carried out in a side area except the edge (farthest edge). The irradiation of laser is carried out by intermittently irradiating with the laser the continuous laminate under running with the laser head being fixed on the (both) side(s) of the continuous laminate.
Since the hard coat layer 16 comprises synthetic resin, the hard coat layer 16 in the area that has been irradiated with a laser decomposes or bums to disappear. However, when the substrate is made of PET that is apt to boil by irradiation of laser, PET located at the interface of the hard coat layer 16 boils to blow out the hard coat layer 16. Hence, the hard coat layer 16 located in the vicinity of the both side edges is removed to expose a large number of island-shaped conductive layer areas, whereby an exposed area of conductive metal layer 13' as an intermittent band-shaped region is formed to construct an electrode part (step 4). Thereby a hard coat layer is left at the edge of the transparent substrate 12 because it is not irradiated with the laser, hence forming an edge-area hard coat layer 16.
In case the group of island-shaped conductive layer areas is formed in the form of two or more rows, the formation is carried out by using two or more lasers or by repeating the procedure as mentioned above with shifting the location of the irradiation.
In the process of Fig. 1, the continuous transparent substrate as used above generally has such size that the width of one of the resultant optical filters corresponds to the width of the substrate. However, for example, a continuous transparent substrate having such size that the twice widths of one of the resultant optical filters correspond to the width of the substrate may be used, and not only the both sides but also the center of the laminate may be irradiated with a pulse laser by, for example, setting two lasers in the center parallel to the edge side too, whereby two optical filters can be obtained in the width direction of the substrate.
It is preferred that an adhesion layer of polyester resin is provided between the transparent substrate and the conductive metal layer 13 in order to enhance adhesion properties therebetween.

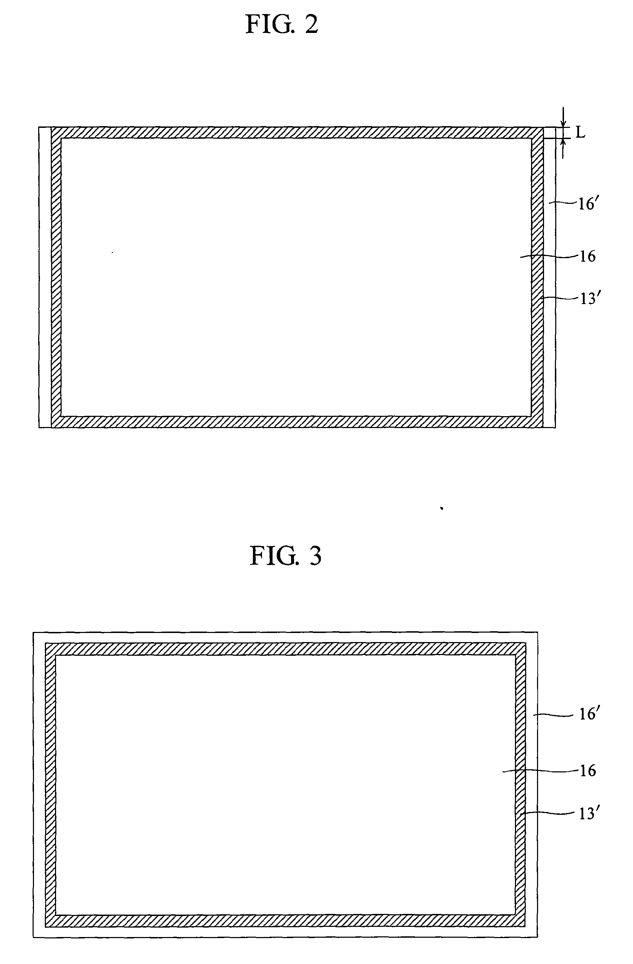

Alternatively, before the above-mentioned step (laser-irradiation of edge side) or after the step, the hard coat layer of the continuous laminate having exposed conductive layer may be intermittently irradiated with a laser in the width direction by, for example, using two lasers, which removes the irradiated portion of the hard coat layer 16 to expose the conductive metal layer in the width direction. In case the procedure is continuously carried out by irradiating the adjacent regions of both side edges with a laser, the laminate having conductive metal layer exposed in the whole periphery can be obtained (see Fig. 2). The laser irradiation in the width direction is generally carried out by stopping the laminate (filter) under running and moving the laser in the width direction. Alternatively, a continuous laminate may be cut in the form of rectangle and the cut laminate may be intermittently irradiated with a laser along periphery of the rectangle.

Alternatively, the laser irradiation step (step 3) as mentioned above can be also carried out by fixing a continuous laminate on a rectangular glass plate (for example, by using a transparent adhesive layer 15), cutting the continuous laminate along the periphery of the rectangular glass plate (a laser may be used for the cutting), and intermittently irradiating the adjacent regions of both side edges or the adjacent region of periphery edge of the rectangular laminate with a laser to expose a conductive metal layer, whereby a rectangular optical filter having a conductive metal layer exposed area (electrode part) in the adjacent regions of both side edges or the adjacent region of periphery edge can be obtained. In case the optical filter has a frame-shaped electrode part in the periphery, the plain view is shown in Fig. 3 (a hard coat layer is left in the farthest edge). In this step, the continuous laminate is fixed on the glass plate to be free of occurrence of position gap or lifting of the laminate, and hence the laser irradiation can be accurately carried out in the predetermined position to bring about an optical filter having excellent appearance. Accordingly, the adoption of the step is preferred.
On the reverse side (generally whole surface) of the continuous transparent substrate 12, a near-infrared absorption layer 14 as other functional layer and a transparent adhesive layer 15 thereon may be provided. Such structure corresponds to one preferred embodiment of the optical filter of the invention. The transparent adhesive layer 15 may not provided. Various conductive materials for ground are connected to the electrode part (exposed area of conductive metal layer 13") of the resultant optical filter. The hard coat layer is shown as one kind of the functional layer of the invention.
Alternatively, after the formation of the electrode part as mentioned above, a near-infrared absorption layer 14 as other functional layer may be formed on the reverse side (generally whole surface) of the transparent substrate 12 and a transparent adhesive layer 15 may be formed on the near-infrared absorption layer 14. The transparent adhesive layer 15 may be not formed.

Though these are the explanation with respect to the process for the preparation of an optical filter by using continuous transparent substrate, a rectangular optical filter (generally for one or two displayed surface of display) can be also prepared in the same manner. In more detail, a mesh-shaped conductive metal layer 13 is formed on a whole surface of a rectangular transparent substrate 12 (step 1), and subsequently a hard coat layer 16 comprising synthetic resin as a first functional layer is formed on a whole surface of the mesh-shaped conductive metal layer 13 (step 2). For example, the side edge of the hard coat layer 16 of the laminate as prepared above is intermittently irradiated with a laser (step 3). The radiation may be carried out with respect to the side edge of the whole periphery by using one pulse laser. Or the both side edges may be irradiated with two pulse lasers. In case two or more rows of island-shaped conductive layer areas are formed, it is general that the same procedure is repeated. Since the hard coat layer 16 comprises synthetic resin, the hard coat layer 16 in the area that has been irradiated with laser decomposes or bums to disappear. Hence, the hard coat layer 16 is removed, whereby a large number of island-shaped conductive layer areas are exposed. Thus an exposed area of conductive metal layer 13' is formed, which corresponds to an electrode part (step 4; see Figs. 1 and 3). In the process, the hard coat layer in the (farthest) edge area is not irradiated with laser, and hence the hard coat layer remaining in the edge area constitutes an edge-area hard coat layer 16'.

In the optical filter of the invention obtained as above, a large number of island-shaped areas (island-shaped conductive metal layer areas) are formed in the form of an intermittent band-shaped region. The width (perpendicular width; L in Figs. 2, 4 and 5) of the intermittent band-shaped region (exposed area of band-shaped conductive metal layer) is generally in the range of 1 to 100mm, especially 2 to 50mm. Further, the width of the narrow band-shaped area of the edge-area hard coat layer 16' is generally in the range of 0.1 to 20mm, especially 0.5 to 5mm.
In the optical filter of the invention, the island-shaped conductive layer (i.e., intermittent band-shaped region) is formed such that the number of the island-shaped areas (island-shaped conductive metal layer areas) is 25 to 250/cm², preferably 20 to 200/cm² in the intermittent band-shaped region, and an area ratio of the island-shaped areas is 2 to 50%, preferably 15 to 50%, especially 20 to 40% based on the intermittent band-shaped region. By intermittently irradiating the functional layer with a laser so as to satisfy the above-mentioned conditions, the irradiated portion of the functional layer can be removed with suppressing peeling of the conductive metal layer from the transparent substrate, whereby the optical filter free of defect can be easily prepared. The electrode part formed as above is the portion of the conductive metal layer clearly exposed in the periphery of the optical filter, and therefore can be easily grounded.

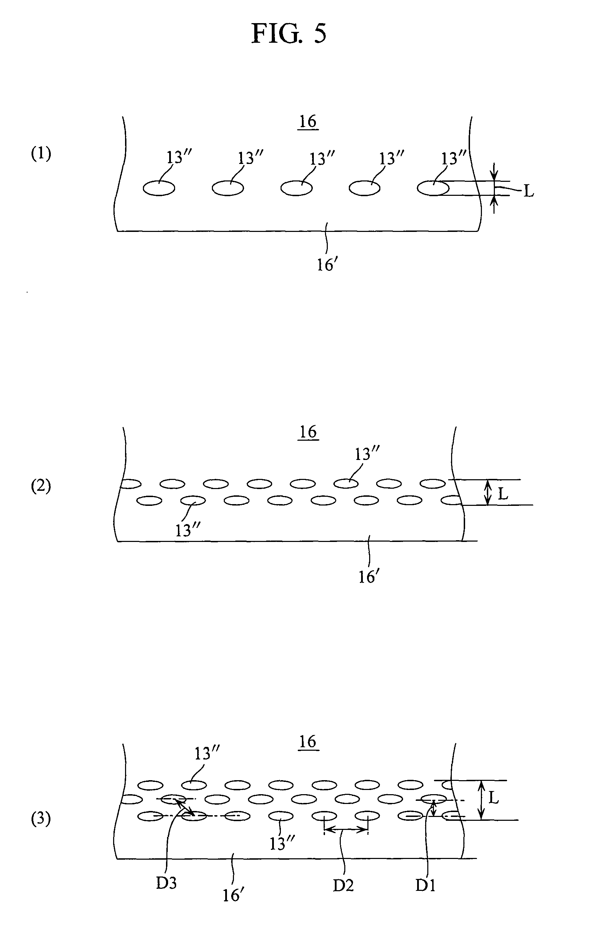

The exposed area of conductive metal layer 13'shown in Figs. 1 to 4 corresponds to the intermittent band-shaped region (intermittent island-shaped region). In the invention, the intermittent band-shaped region is defined by a band-shaped area having a perpendicular width between the most inside point and the most outside point of the island-shaped areas. The region corresponds to, for example, a band-shaped region having the width represented by "L" shown in Fig. 2 and Fig. 5 described later. The number of the island-shaped areas (island-shaped conductive metal layer areas) is 25 to 250/cm², in the intermittent band-shaped region having the width of the "L", and an area ratio of the island-shaped areas is 2 to 50% (preferably 15 to 50%), based on the intermittent band-shaped region having the width of the "L".
Preferred embodiments of the exposed are of conductive metal layer corresponding to the intermittent band-shaped region are shown in Fig. 5 (1)-(3). Fig. 5 (1) shows that island-shaped areas 13" are formed in the form of band and in a line to produce the exposed area of conductive metal layer 13'. Fig. 5 (2) shows that island-shaped areas 13" are formed in the form of band, in two lines and in a zigzag manner to produce the exposed area of conductive metal layer 13'. In this case, the island-shaped areas 13" may be formed in the form of band and in two lines without misalignment (shifting) with respect to location relationship between island-shaped areas in the two lines, but the location relationship is preferably in zigzag. Fig. 5 (3) shows that island-shaped areas 13" are formed in the form of band, in three lines and in a zigzag manner to produce the exposed area of conductive metal layer 13'. The location relationship between island-shaped areas in the three lines is in zigzag one another. Naturally the island-shaped areas 13" may be formed in four or more lines. The intermittent band-shaped region of the invention corresponds to a band-shaped area having a perpendicular width between the most inside point of the most inside island-shaped area 13" of the island-shaped areas 13" in the inside row and the most outside point of the most outside island-shaped area 13" of the island-shaped areas 13" in the outside row, and therefore the perpendicular width is "L".
The shape of the island-shaped areas 13" may be any shape such as rectangle, ellipse, circle, polygon. The sizes of island-shaped areas 13" are the same as each other or different from each other. The sizes generally are the same as each other.

The island-shaped areas 13" are formed as aggregation of many ellipse areas arranged parallel to each side as shown in Fig. 5, and the exposed area of conductive metal layer 13', which is electrode for grounding, are generally formed from plural rows of the island-shaped areas. The size of each of island-shaped areas 13" depends upon a beam diameter of a laser beam emitted from a leaser head, magnification of a beam expander provided on the way, curvature and focal length of lens(es), optical path length, beam strength and beam profile. A distance D2 between the island-shaped areas 13" in the row direction (distance between the centers of the island-shaped areas 13" adjacent in the row direction) D2 is determined from moving speed of head and oscillating frequency of laser, and preferably is approximately {(maximum radius of island-shaped area 13") × 2 + 0.3}mm. Distance D1 between rows is also determined in the same manner as D2. Distance D3 between island-shaped areas 13" adjacent between rows is also determined in the same manner as D2. The maximum radius of the island-shaped area 13" generally is 0.1 to 10mm, preferably 0.2 to 1.0mm. The area of the island-shaped area 13" generally is 0.1 to 30mm², preferably 0.1 to 5mm².

Though a first functional layer such as hard coat layer is advantageously removed by using a continuous-wave laser in order to effectively form the island-shaped area 13", the use of the continuous-wave laser is apt to give excess heat to the irradiated portion and therefore heat damage easily occurs in the irradiated portion, the heat damage including peeling of a mesh-shaped conductive layer of a laminate (e.g., a transparent substrate, a mesh-shaped conductive layer and a hard coat layer). The hard coat layer generally has an extremely small thickness of 5 to 7µm, and therefore the conductive layer under the hard coat layer is apt to suffer from heat damage. However, the use of a pulse laser (especially having infrared wavelength) enables avoidance of the heat damage and is preferred. In case a pulse laser is used as a laser, the use of a short-pulse laser having short wavelength enables reduction of heat damage. However, the use of a short-pulse laser requires long time period for processing, and therefore a pulse laser having long wavelength is used with increased distance between shots, whereby effective exposed area of conductive metal layer 13' can be ensured with suppressing reduction of adhesion of a mesh-shaped conductive layer at the minimum.
A wavelength of the pulse laser is preferably 0.2 to 30µm, more preferably 5 to 15 µm. A pulse width of the pulse laser (especially CO₂ laser) is preferably 1 to 1,000 microseconds, more preferably 100 to 800 microseconds. Thereby the effect suppressing the heat damage can be easily obtained. The pulse of the pulse laser per se can be used for the formation of the island-shaped area 13" (in which the pulse generally has hundreds microseconds). However, in case the pulse laser is a short pulse (generally the pulse being less than 100 microseconds), it can be also used by turning a group of predetermined number of pulses on or off. The use of the short pulse (the latter) is preferred in view of effect suppressing peel failure.
The number of the island-shaped conductive metal layer areas (island-shaped areas) of 25 to 250/cm² and an area ratio of the island-shaped conductive metal layer areas of 2 to 50% (preferably 15 to 50%) according to the present invention, can be easily obtained by using the above-mentioned pulse laser under appropriate conditions (e.g., relative moving speed, output, interval of on/off, etc.) with heat damage of the laminate being suppressed at the minimum. Further it is preferred to satisfy the distances D1 and D2 between rows, distance D3 between island-shaped areas 13" and the maximum radius of the island-shaped areas 13", which are mentioned previously.

The functional layer and other functional layer(s) generally are any layer comprising synthetic resin showing some kind of function. In the invention, the functional layer generally is a hard coat layer; or comprises a hard coat layer and a low refractive index layer having refractive index lower than that of the hard coat layer, the hard coat layer being in contact with the conductive metal layer; or comprises a hard coat layer, a high refractive index layer having refractive index higher than that of the hard coat layer and a low refractive index layer having refractive index lower than that of the hard coat layer, the hard coat layer being in contact with the conductive metal layer. The increase of the number of the layers brings about more excellent antireflection properties. Alternatively, the functional layer is preferably an anti-glare layer; or comprises an anti-glare layer and a low refractive index layer having refractive index lower than that of the anti-glare layer, the anti-glare layer being in contact with the conductive metal layer. The anti-glare layer generally shows excellent antireflection effect, and therefore the provision of the anti-glare layer often brings about no provision of the above-mentioned antireflection layer. The provision of the anti-glare layer enhances freedom degree with respect to selection of refractive index of other layers to broaden the options of materials of the layers, whereby reduction of cost can be also obtained. The combination of the anti-glare layer and low refractive index layer brings about more excellent antireflection properties compared with only the anti-glare layer. Further other functional layer(s) is generally a near-infrared absorption layer, a neon-cut layer, a transparent adhesive layer, or the combination of these two or more layers. In the invention, it is preferred that the other functional layer is a transparent adhesive layer having near-infrared absorption function and neon-cut function; or that the other functional layer comprises a near-infrared absorption layer having neon-cut function and a transparent adhesive layer, superposed in this order on the transparent substrate; or that the other functional layer comprises a near-infrared absorption layer, a neon-cut layer and a transparent adhesive layer, superposed in this order on the transparent substrate.

On the hard coat layer 16, a low refractive index layer having lower refractive index than that of the hard coat layer is preferably provided in order to enhance antireflection property. In the case, the low refractive index layer is generally formed on the whole surface of the hard coat layer. Provision of the hard coat layer and the low refractive index layer is performed by coating and (light) curing with respect to each layer separately, or by coating with respect to each layer and then (light) curing with respect to these layers at a time. Though the hard coat layer 16 is provided on the conductive metal layer, an anti-glare layer and if desired the low refractive index layer is also preferably provided on the conductive metal layer according to desired design of the optical filter. The anti-glare layer preferably is a hard coat layer having anti-glare function.

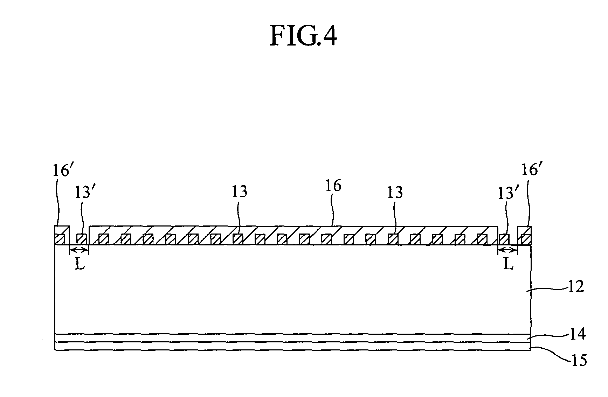

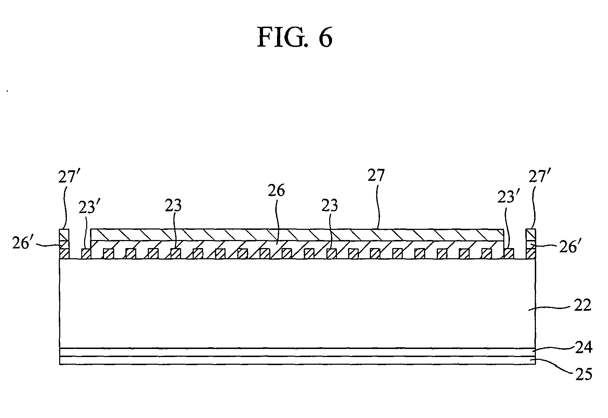

An example of preferred embodiments of an optical filter having the structure that a near infrared absorption layer 14 and a transparent adhesive layer 15 thereon are provided on the reverse side of the optical filter of the invention as shown in Fig. 1 is shown in Fig. 4, as mentioned above. Further, an example of a schematic section view of an optical filter having the structure that a low refractive index layer (antireflection layer) is further provided on the hard coat layer of the optical filter of the invention as shown in Fig. 4 is shown in Fig. 6. In Fig. 6, a mesh-shaped conductive metal layer 23, a hard coat layer 26 and a low refractive index layer 27 are provided on one surface of a transparent substrate 22 in this order, and a near-infrared absorption layer 24 and a transparent adhesive layer 25 are provided on the other surface of the transparent substrate 22 in this order. The area adjacent to the edge of the surface of low refractive index layer 27 is irradiated with a laser. As for the hard coat layer 26, an edge-area hard coat layer 26' is provided on the conductive metal layer 23' in an edge area (farthest outside area) outside an exposed area of conductive metal layer 23', and as for the low refractive index layer 27, an edge-area low refractive index layer 27' is provided on the edge-area hard coat layer 26' in the edge area outside an exposed area of conductive metal layer 23'. Any layers (e.g., high refractive index layer) provided on the hard coat layer 26 (26') are provided on the central area and the edge area as well as the low refractive index layer. Further, openings of the mesh-shaped conductive metal layer 24 are filled with the hard coat layer. Thereby the transparency is enhanced. The mesh-shaped conductive metal layer 14 is the same as 24. As mentioned above, an anti-glare layer is also preferably provided instead of the hard coat layer 26.

In the above-mentioned structure, the location of the hard coat layer 26 and the low refractive index layer (antireflection layers) 27 may be exchanged with that of the near-infrared absorption layer 24 each other. Further, the near-infrared absorption layer 24 may be provided between the conductive metal layer 23 and the hard coat layer 26. However, the structure of Fig. 6 is advantageous in easiness of provision of ground because, after attachment of the optical filter to a display, the conductive layer is located in front side (obverse side) of the display.

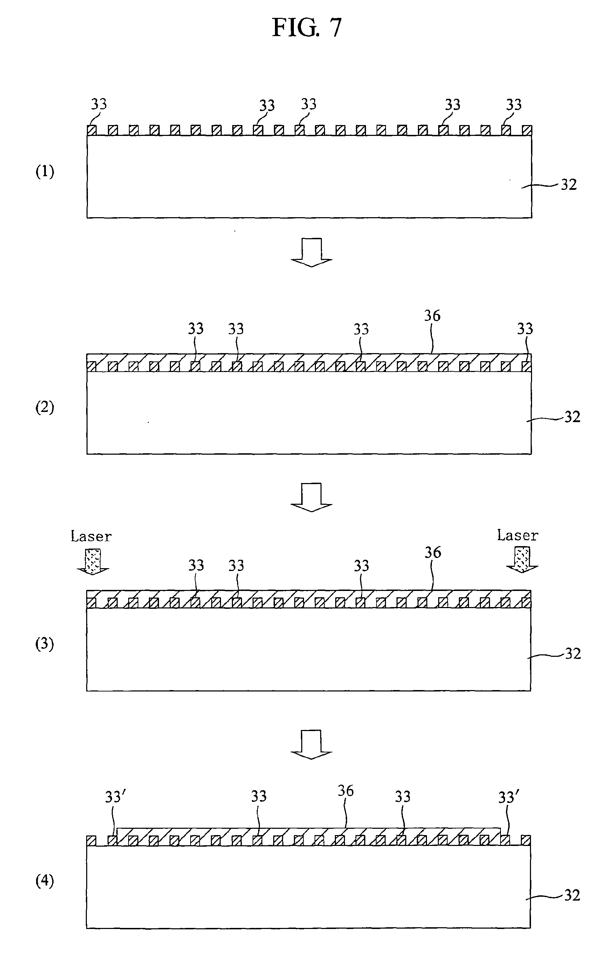

Fig. 1 explains an embodiment of an exposed area of conductive metal layer that is provided on a side edge area but that has edge-area hard coat layer, etc. outside the side edge area. The present invention includes an embodiment of an exposed area of conductive metal layer that has no hard coat layer on a side edge area, i.e., an embodiment that an exposed area of conductive metal layer is present on the farthest edge area. Such embodiment is explained by referring to Fig. 7.

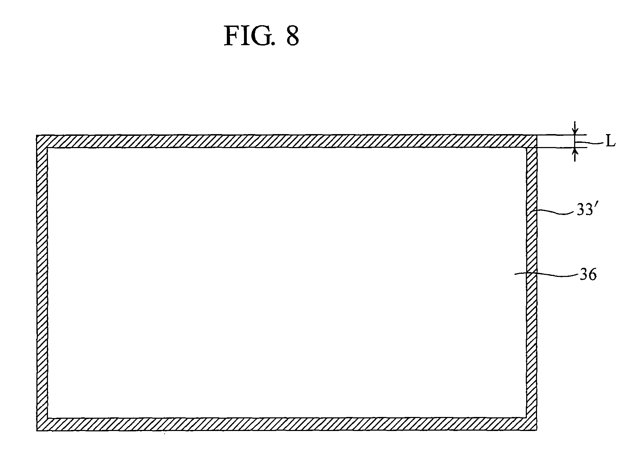

A schematic section view for explaining other example of the process for the preparation of the optical filter for display provided with electrode part according to the present invention is shown in Fig. 7.
A mesh-shaped conductive metal layer 33 is formed on a whole surface of a continuous transparent substrate 32 (step 1), and subsequently a hard coat layer 36 comprising synthetic resin as a functional layer is formed on a whole surface of the mesh-shaped conductive metal layer 33 (step 2). For example, the continuous laminate as prepared above is wound in the form of roll, the continuous laminate is continuously fed from the roll by means of, for example, roll-to-roll system, and the side edge of the hard coat layer 16 is intermittently irradiated with a laser (step 3). Both the side edges may be simultaneously irradiated, or one side edge may be irradiated and thereafter another side edge may be done. The irradiation of laser is carried out in the farthest edge (side edge).
Since the hard coat layer 36 comprises synthetic resin, the hard coat layer 36 in the area that has been irradiated with a laser decomposes or bums to disappear. Hence, the hard coat layer 36 located in the both side edges is removed, which exposes a large number of island-shaped conductive layer areas, whereby an exposed area of conductive metal layer 33' as an intermittent band-shaped region is formed to construct an electrode part (step 4). In case the hard coat layer is irradiated with the laser such that the hard coat layer is not left at the farthest edge, the irradiation should be carried out so as not to soften and deform the transparent substrate. Thereafter, a near-infrared absorption layer 34 and a transparent adhesive layer 35 as other functional layers are provided on the other surface (generally whole surface) of the transparent substrate 32 in this order. Then the resultant laminate is cut in the width direction, whereby a rectangular optical filter provided with an exposed area of conductive metal layer (electrode part) 33' in the periphery can be obtained. The cutting may be performed by a cutting machine. In this case, if necessary, the conductive metal layer is exposed in the width direction by a laser. When the laminate is cut by the irradiation of a laser, the irradiated areas occasionally are not island-shaped areas. Such areas are not included in the intermittent band-shaped region of the invention. A plain view of the resultant optical filter is shown in Fig. 8. The process indicated in Fig. 7 brings about one optical filter in the width direction. However, the laser irradiation may be performed on not only the both sides but also the center, for example, by setting lasers in two points of the center in the same manner as in Fig. 1, whereby two optical filters can be obtained in the width direction.
Alternatively, during the above-mentioned step (laser-irradiation of side edge) or after the step, the hard coat layer 36 of the continuous laminate (having exposed conductive layer) may be intermittently irradiated with a laser in the width direction, which removes the irradiated portion of the hard coat layer 36 to expose the conductive metal layer in the width direction. In case these procedures including the procedure irradiating the both side edges with a laser are carried out continuously, the laminate having conductive metal layer exposed in the whole periphery can be obtained (see Fig. 8). The laser irradiation in the width direction is generally carried out by stopping the laminate (filter) under running and moving the laser in the width direction.

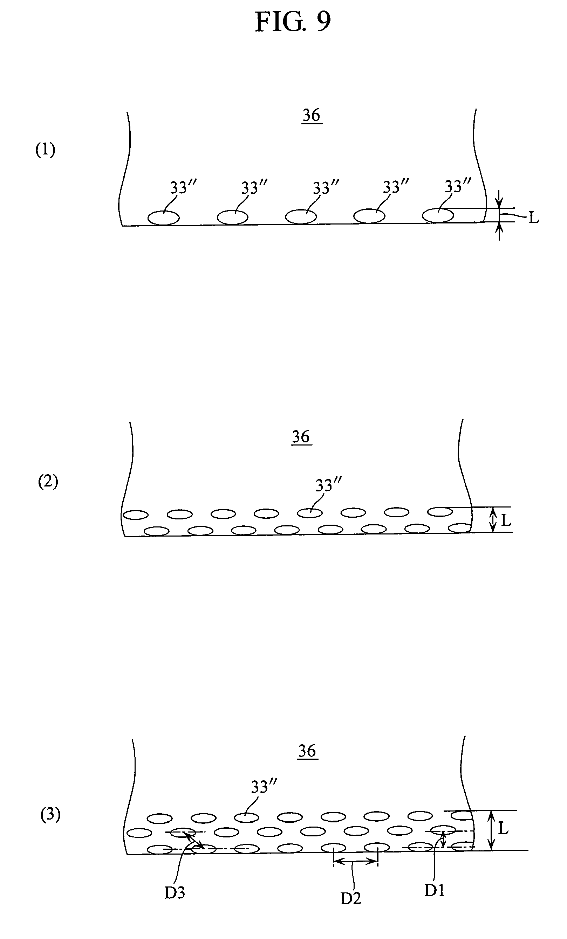

The exposed area of conductive metal layer 33' shown in Figs. 7 and 8 is the intermittent band-shaped region (intermittent island-shaped region). In the invention, the intermittent band-shaped region is defined by a band-shaped area having a perpendicular width between the most inside point and the most outside point of the island-shaped areas. The region corresponds to, for example, a band-shaped area having the width represented by "L" shown in Fig. 8 and Fig. 9 described later. The number of the island-shaped areas (island-shaped conductive metal layer areas) is 25 to 250/cm² in the intermittent band-shaped region having the width of the "L", and an area ratio of the island-shaped areas is 2 to 50% (preferably 15 to 50%), based on the intermittent band-shaped region having the width of the "L".
Preferred embodiments of the exposed are of conductive metal layer corresponding to the intermittent band-shaped region are shown in Fig. 9 (1)-(3). Fig. 9 (1) shows that island-shaped areas 33" are formed in the form of band and in line to produce the exposed area of conductive metal layer 33'. Fig. 9 (2) shows that island-shaped areas 33" are formed in the form of band, in two lines and in a zigzag to produce the exposed area of conductive metal layer 33'. In this case, the island-shaped areas 33" may be formed in the form of band and in two lines without misalignment (shifting) with respect to location relationship between island-shaped areas in the two lines, but the location relationship is preferably in a zigzag. Fig. 9 (3) shows that island-shaped areas 33" are formed in the form of band, in three lines and in azigzag to produce the exposed area of conductive metal layer 33'. The location relationship between island-shaped areas in the three lines is in zigzag one another. Naturally the island-shaped areas 33" may be formed in four or more lines.
The shape of the island-shaped areas 33" may be any shape such as rectangle, ellipse, circle, polygon. The sizes of island-shaped areas 33" are the same as each other or different from each other. The sizes generally are the same as each other.

The island-shaped areas 33" are formed as aggregation of many ellipse areas arranged parallel to each side as shown in Fig. 9, and the exposed area of conductive metal layer 33', which is electrode for grounding, are generally formed from plural rows of the island-shaped areas. The size of each of island-shaped areas 33" depends upon a beam diameter of a laser beam emitted from a leaser head, magnification of a beam expander provided on the way, curvature and focal length of lens(es), beam strength and beam profile. A distance D2 between the island-shaped areas 33" in the row direction (distance between the centers of the island-shaped areas 33" adjacent in the row direction) D2 is determined from moving speed of head and oscillating frequency, and preferably is approximately {(maximum radius of island-shaped area 33") × 2 + 0.3}mm. Distance D1 between rows is also determined in the same manner as D2. Distance D3 between island-shaped areas 33" adjacent between rows is also determined in the same manner as D2. The maximum radius of the island-shaped area 33" generally is 0.1 to 10mm, preferably 0.2 to 1.0mm. The area of the island-shaped area 33" generally is 0.1 to 30mm², preferably 0.1 to 5mm².

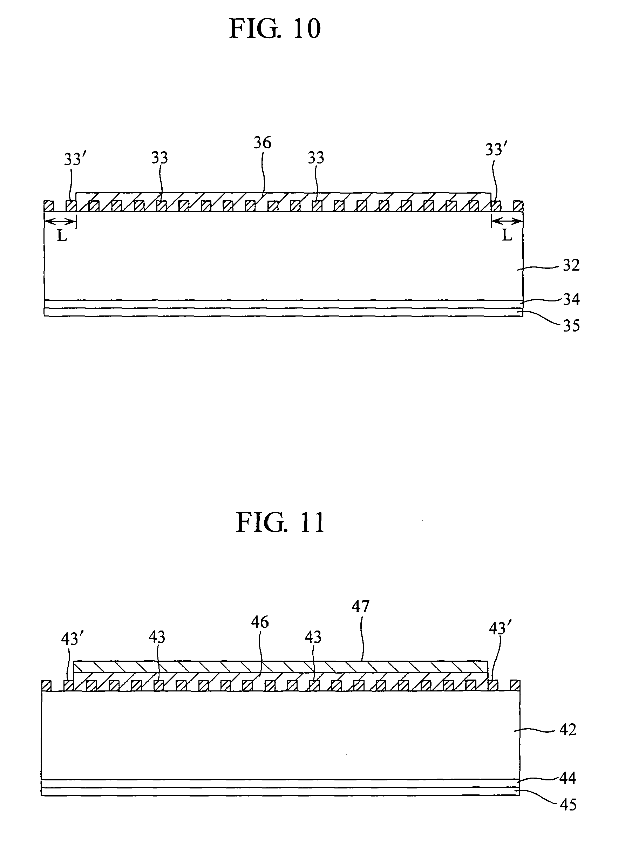

A near-infrared absorption layer 34 as a second functional layer and a transparent adhesive layer 35 thereon may be provided on the reverse side (generally whole surface) of the continuous transparent substrate 32. This structure corresponds to a preferred embodiment of the optical filter of the invention as shown Fig. 10. The transparent adhesive layer 35 may be not provided. Various conductive materials can be connected to the electrode part (exposed area of conductive metal layer 33') of the resultant optical filter. The hard coat layer corresponds to one functional layer of the invention.
Alternatively, after the formation of the electrode part as mentioned above, a near-infrared absorption layer 34 as other functional layer may be formed on the reverse side (generally whole surface) of the transparent substrate 32 and a transparent adhesive layer 35 may be formed on the near-infrared absorption layer 34. The transparent adhesive layer 35 may be not formed.
The exposed area of conductive metal layer 33' is used as an electrode part for grounding. The width ("L" of Figs. 8-10) of this intermittent band-shaped region generally is 2 to 100mm, especially 5 to 50mm.

On the hard coat layer 36, a low refractive index layer having lower refractive index than that of the hard coat layer 36 is preferably provided in order to enhance antireflection property. In the case, the low refractive index layer is generally formed on the whole surface of the hard coat layer. Provision of the hard coat layer and the low refractive index layer is performed by coating and (light) curing with respect to each layer separately, or by coating with respect to each layer and then (light) curing with respect to these layers at a time. Though the hard coat layer 36 is provided on the conductive metal layer, an anti-glare layer and if desired the low refractive index layer is also preferably provided on the conductive metal layer according to desired design of the optical filter.

An example of a schematic section view of an optical filter having the structure that a low refractive index layer (antireflection layer) is further provided on the hard coat layer of the optical filter of the invention as shown in Fig. 10 is shown in Fig. 11. In Fig. 11, a mesh-shaped conductive metal layer 43, a hard coat layer 46 and a low refractive index layer 47 are provided on one surface of a transparent substrate 42 in this order, and a near-infrared absorption layer 44 and a transparent adhesive layer 45 are provided on the other surface of the transparent substrate 42 in this order. The area adjacent to the edge area of the surface of low refractive index layer 47 is irradiated with a laser. Similarly as shown in Fig. 10, an exposed area of conductive metal layer 43' is present in the side edges. Any layer (e.g., high refractive index layer) on the hard coat layer 46 are provided on the central area as well as the low refractive index layer 47. Further, openings of the mesh-shaped conductive metal layer 44 are filled with the hard coat layer. Thereby the transparency is enhanced.
In the above-mentioned structure, the location of the hard coat layer 46 and the low refractive index layer (antireflection layers) 47 may be exchanged with that of the near-infrared absorption layer 44 each other. Further, the near-infrared absorption layer 44 may be provided between the conductive metal layer 43 and the hard coat layer 46. However, the structure of Fig. 11 is advantageous in easiness of provision of ground because, after attachment of the optical filter to a display, the conductive layer is located in front side (obverse side) of the display.

The conductive metal layer 13, 23 etc. is, for example, a mesh-shaped metal layer or metal-containing layer, a metal oxide layer (dielectric material layer), or an alternately laminated layer of metal oxide layer and metal layer. The mesh-shaped metal layer or metal-containing layer is generally a layer formed by etching method or printing method, or a metal fiber layer, whereby a low resistance can be easily obtained. The openings of the mesh-shaped metal layer or metal-containing layer are generally filled with the hard coat layer 16, 26 or the anti-glare layer as mentioned above, whereby enhanced transparency can be obtained. In case the openings are not filled with the hard coat layer 16, 26, they are preferably filled with other layer, for example, a near-infrared absorption layer 14, 24 or a transparent resin layer therefor.
The low refractive index layer 27 etc. constitutes an antireflection layer. In more detail, a composite layer of the hard coat layer 16, 26 and low refractive index layer provided thereon shows efficiently antireflection effect. A high refractive index layer may be provided between the hard coat layer and low refractive index layer to further enhance the antireflection effect.
The low refractive index layer may not be provided and only the hard coat layer 16, 26, which has lower or higher (preferably lower) refractive index than that of the transparent substrate, may be provided. The hard coat layer 16, 26 and the antireflection layer are generally formed by application, which is preferred in view of productivity and economic efficiency.
The near-infrared absorption layer 14, 24 etc. has a function that shields (cuts) undesired light such as neon light of PDP. The layer generally contains a dye having absorption maximum of 800 to 1200nm. The transparent adhesive layer 15, 25 is generally provided to easily attach the display filter to a display. The release sheet may be provided on the transparent adhesive layer 15.
The electrode part is a conductive metal layer provided in the periphery of the optical filter, and its width (L of Fig. 2 etc.) is generally 2 to 100mm, especially preferably 5 to 50mm. The conductive metal layer preferably is a mesh-shaped metal layer.

The above-mentioned rectangle-shaped optical filter for display has one transparent substrate, but may have two transparent substrates. For example, a transparent substrate having an antireflection layer such as a hard coat layer and a low refractive index layer is superposed on a conductive metal layer of a transparent substrate having the conductive metal layer thereon (generally further having a near-infrared absorption layer, etc. on its back side) through an adhesive layer such that the back side of the former transparent substrate is in contact with the conductive metal layer, and the antireflection layer such as the hard coat layer and low refractive index layer is irradiated with a laser to produce an optical filter having two transparent substrates. Otherwise, a transparent substrate having a mesh-shaped metal layer and an antireflection layer such as a hard coat layer and a low refractive index layer provided thereon in this order is bonded onto another transparent substrate having a near-infrared absorption layer and an transparent adhesive layer thereon with an adhesive such that the back sides of the two transparent substrates are in contact with each other. The former laminate is prepared by the present process.
Though the use of two transparent substrates is adopted when it is advantageous for the processing of preparation, it has disadvantage of increases of thickness and of volume.
As mentioned above, the rectangle-shaped optical filter for display having one transparent substrate is obtained, for example, by forming a conductive metal layer on a whole surface of a rectangle-shaped transparent substrate, forming an antireflection layer such as a hard coat layer and a low refractive index layer on the conductive metal layer, and forming an exposed area of the conductive layer by laser irradiation and then forming a near-infrared absorption layer and a transparent adhesive layer on the other surface of the transparent substrate. The near-infrared absorption layer and a transparent adhesive layer may be formed beforehand on a surface of the transparent substrate. The prepared filter is designed depending on the shape of display area of front side of each display. The optical filter has a projecting electrode part of conductive layer on its periphery, which forms an electrode part (ground electrode) that can be easily grounded and easily attached to a display.

In the invention, the laser irradiation brings about formation of the exposed area of conductive metal layer as mentioned above. Laser usable in the invention includes any pulsed laser (pulse emitting laser) that is capable of removing a synthetic resin layer for a short time through burning or decomposition of the resin without giving heat damage to the materials constituting the optical filter such as a conductive metal layer, or that can be set in that manner. Laser irradiation technique includes line beam forming technique, laser optical branching technique, double pulse technique and combination thereof. Examples of the pulse laser include YAG laser (fundamental wave, double wave, threefold wave), ruby laser, excimer laser, semiconductor laser, CO₂ laser, argon laser. Preferred are CO₂ laser, because it is capable of removing a synthetic resin layer for an extremely short time through burning or decomposition of the resin, or capable of removing a synthetic resin layer by heating and boiling the resin through absorption of laser. In more detail, the pulse laser generally has a long wavelength, and it is possible to ensure effective exposed area of conductive metal layer 13' by using the pulse laser with heat damage being suppressed at minimum through increased distance between shots.
The wavelength of the pulse laser is generally 0.2 to 30µm, preferably 5 to 15µm, as mentioned above. Further the pulse width of the pulse laser (especially CO₂ laser) is generally 1 to 1,000 microsecond, preferably 100 to 800 microseconds. Thereby the effect to suppress peeling damage caused by heat can be easily obtained. Furthermore, the irradiation of the pulse laser is preferably carried out under the conditions of: output of 5W to 5kW, diameter focused at focus position of 10 to 50µm (however, increasing the diameter on the functional layer to 400 to 1,000µm, for example increasing the diameter to approx. 600µm by appropriately shifting the focus point), and relative moving speed (relative speed between the laminate and the pulse laser) of 1 to 3,000mm/second.

Materials used in the optical filter for display of the present invention are explained below.
The transparent substrate is generally a transparent plastic film. The materials include anything having transparency (the transparency meaning transparency to visible light).
Examples of materials of the plastic films include polyester such as polyethylene terephthalate (PET) and polybutylene terephthalate, acrylic resin such as polymethyl methacrylate (PMMA), polycarbonate (PC), polystyrene, cellulose triacetate, polyvinyl alcohol, polyvinyl chloride, polyvinylidene chloride, polyethylene, ethylene-vinyl acetate copolymer, polyvinyl butyral, metal-crosslinked ethylene-methacrylic acid copolymer, polyurethane and cellophane. Preferred are polyethylene terephthalate (PET), polycarbonate (PC), polymethyl methacrylate (PMMA), because have high resistance to processing load such as heat, solvent and bending. Especially PET is preferred because of excellent processing properties.
The transparent substrate has generally a thickness of 1 µm to 10mm, preferably 1µm to 5mm, particularly 25 to 250µm depending upon the application of the optical filter.

The conductive metal layer of the invention is designed such that surface resistance value of the resultant optical filter generally is not more than 10Ω/□, preferably in the range of 0.001 to5Ω/□, especially in the range of 0.005 to5Ω/□. The mesh-shaped (lattice-shaped) conductive layer is preferred. Otherwise, the conductive layer may be a layer obtained by gas phase coating (deposition), the layer being a transparent conductive layer of metal oxide such as ITO. Further, the conductive layer may be an alternately laminated layer of a dielectric layer of metal oxide such as ITO and a metal layer of Ag (e.g., ITO/Ag/ITO/Ag/ITO).
The mesh-shaped conductive metal layer includes a mesh-shaped metal layer made of metal fiber or metal-coated organic fiber, a layer obtained by etching a metal (e.g., Cu) layer provided on a transparent substrate so as to form mesh having openings, and a layer obtained by printing an electrically conductive ink on a transparent substrate so as to form mesh.
The mesh of the mesh-shaped conductive metal layer preferably has line width of 1µm to 1mm and opening ratio of 40 to 95%, which generally comprises metal fiber or metal-coated organic fiber. Further preferred is a mesh having line width of 10 to 500µm and opening ratio of 50 to 95%. In the mesh-shaped conductive metal layer, line width more than 1mm brings about enhanced electromagnetic-wave shielding property, while opening ratio in reduced. Line width less than 1µm brings about reduction of the strength of the resultant mesh to render its handling difficult. Moreover, opening ratio more than 95% renders keeping of the shape of the mesh difficult, while opening ratio less than 40% brings about reductions of optical transparency and of light amount from a display.
The opening ratio (aperture ratio) of the mesh-shaped conductive metal layer means the proportion of the area of the opening portion of the layer to the projected area of the layer.
Examples of metals for the metal fiber and /or metal-coated organic fiber constituting the mesh-shaped conductive metal layer include copper, stainless, aluminum, nickel, titanium, tungsten, tin, lead, iron, silver, carbon or alloys thereof, preferably copper, stainless or nickel.
Examples of organic materials used in the metal-coated organic fiber include polyester, nylon, polyvinylidene chloride, aramid, Vinylon, and cellulose.
In a patternwise etched conductive foil such as metallic foil, as metals for the metallic foil, copper, stainless, aluminum, nickel, iron, brass or alloys thereof, preferably copper, stainless or aluminum is used.
In case of decreasing the thickness of the metallic foil to excess, handling of the foil and workability of pattern etching are reduced. In case of increasing the thickness to excess, a thickness of the resultant filter is increased and time period requiring for etching procedure is lengthened. Therefore the thickness of the conductive layer preferably is in the range of 1 to 200 µm.
The etched pattern may have any shapes. For example, the metallic foil is in the form of stripe, which is obtained by forming square openings (pores) on the foil, or in the form of punching metal, which is obtained by forming circle, hexagon, triangle or ellipse pores. The pores may be regularly arranged or irregularly arranged to form a random pattern. The proportion of the area of the opening portion to the projected area of the metal foil is preferably in the range of 20 to 95%.
Besides above, material soluble in a solvent is dot-wise applied to a film to form dots, a conductive material layer insoluble in the solvent is formed on the film, and the film is brought in contact with the solvent to remove the dots and the conductive material layer provided on the dots whereby a mesh-shaped conductive metal layer can be obtained. The mesh-shaped conductive metal layer may be used in the invention.
A plated layer (metallic deposit) may be further provided on the conductive metal layer in order to enhance the conductivity. Particularly, it is preferred to form the plated layer on the layer obtained by the above-mentioned process that dots are formed by using material soluble in a solvent. The plated layer can be formed by conventional electrolytic plating method and nonelectrolytic plating method. Examples of metals used in the plating generally include copper, copper alloy, nickel, aluminum, silver, gold, zinc or tin. Preferred is copper, copper alloy, silver or nickel, particularly copper or copper alloy is preferred in view of economic efficiency and conductive property.
Further anti-glare property may be added to the conductive layer. In a step of the anti-glare treatment, a blackened treatment may be carried out on a surface of the (mesh-shaped) conductive layer. For example, oxidation treatment of metal layer, black plating of chromium alloy, or application of black or dark color ink can be carried out.

The antireflection layer of the invention generally is a laminated layer of a hard coat layer having lower refractive index than that of the transparent substrate as a substrate and a low refractive index layer having lower refractive index than that of the hard coat layer; or is a laminated layer of a hard coat layer, a low refractive index and a high refractive index layer provided therebetween. The antireflection layer may be only a hard coat layer having lower refractive index than that of the transparent substrate as a substrate, which has antireflection effect. However, in case the transparent substrate has low refractive index, the antireflection layer may be a laminated layer of a hard coat layer having higher refractive index than that of the transparent substrate and a low refractive index layer; or a laminated layer of a hard coat layer, a low refractive index and a high refractive index layer provided thereon. The hard coat layer is a layer mainly consisting of synthetic resin such as acrylic resin, epoxy resin, urethane resin, silicon resin, etc. The hard coat layer generally has a thickness of 1 to 50µm, preferably 1 to 10µm. The synthetic resin is generally thermosetting resin or ultraviolet curable resin, preferred ultraviolet curable resin. The ultraviolet curable resin can be cured for a short time period, and hence has excellent productivity. Further it is preferably deleted easily by laser irradiation. Examples of the thermosetting resin include phenol resin, resorcinol resin, urea resin, melamine resin, epoxy resin, acrylic resin, urethane resin, furan resin and silicon resin. The hard coat layer preferably is a cured layer of an ultraviolet curable resin composition, which comprises ultraviolet curable resin, photopolymerization initiator, etc. The layer generally has a thickness of 1 to 50µm, preferably 1 to 10µm. Examples of the ultraviolet curable resins (monomers, oligomers) include (meth)acrylate monomers such as 2-hydroxyethyl (meth)acrylate, 2-hydroxyropyl (meth)acrylate, 4-hydroxybutyl (meth)acrylate, 2-ethylhexylpolyethoxy (meth)acrylate, benzyl (meth)acrylate, isobornyl (meth)acrylate, phenyloxyethyl (meth)acrylate, tricyclodecane mono(meth)acrylate, dicyclopentenyloxyethyl (meth)acrylate, tetrahydrofurfuryl (meth)acrylate, acryloylmorpholine, N-vinylcaprolactam, 2-hydroxy-3-phenyloxypropyl (meth)acrylate, o-phenylphenyloxyethyl (meth)acrylate, neopentylglycol di(meth)acrylate, neopentyl glycol dipropoxy di(meth)acrylate, neopentyl glycol hydroxypivalate di(meth)acrylate, tricyclodecanedimethylol di(meth)acrylate, 1,6-hexanediol di(meth)acrylate, nonanediol di(meth)acrylate, trimethylolpropane tri(meth)acrylate, pentaerythritol tri(meth)acrylate, pentaerythritol tetra(meth)acrylate, tris[(meth)acryloxyethyl]isocyanurate and ditrimethylolpropane tetra(meth)acrylate; and
the following (meth)acrylate oligomer such as:
polyurethane (meth)acrylate such as compounds obtained by reaction among the following polyol compound and the following organic polyisocyanate compound and the following hydroxyl-containing (meth)acrylate:
the polyol compound (e.g., polyol such as ethylene glycol, propylene glycol, neopentyl glycol, 1,6-hexanediol, 3-methyl-1,5-pentanediol, 1,9-nonanediol, 2-ethyl-2-butyl-1,3-propanediol, trimethylolpropane, diethylene glycol, dipropylene glycol, polypropylene glycol, 1,4-dimethylolcyclohexane, bisphenol-A polyethoxydiol and polytetramethylene glycol; polyesterpolyol obtained by reaction of the above-mentioned polyol with polybasic acid or anhydride thereof such as succinic acid, maleic acid, itaconic acid, adipic acid, hydrogenated dimer acid, phthalic acid, isophthalic acid and terephthalic acid; polycaprolactone polyol obtained by reaction of the above-mentioned polyol with ε-caprolactone; a compound obtained by reaction of the above-mentioned polyol and a reaction product of the above-mentioned polybasic acid or anhydride thereof and ε-caprolactone; polycarbonate polyol; or polymer polyol), and
the organic polyisocyanate compound (e.g., tolylene diisocyanate, isophorone diisocyanate, xylylene diisocyanate, diphenylmethane-4,4'-diisocyanate, dicyclopentanyl diisocyanate, hexamethylene diisocyanate, 2,4,4'-trimethylhexamethylene diisocyanate, 2,2',4-trimethylhexamethylene diisocyanate), and
the hydroxyl-containing (meth)acrylate (e.g., 2-hydroxyethyl (meth)acrylate, 2-hydroxyropyl (meth)acrylate, 4-hydroxybutyl (meth)acrylate, 2-hydroxy-3-phenyloxypropyl (meth)acrylate, cyclohexane-1,4-dimethylolmono(meth)acrylate, pentaerythritol tri(meth)acrylate or glycerol di(meth)acrylate);
bisphenol-type epoxy(meth)acrylate obtained by reaction of bisphenol-A epoxy resin or bisphenol-F epoxy resin and (meth)acrylic acid.
These compounds can be employed singly or in combination of two or more kinds. The ultraviolet curable resin can be used together with thermo polymerization initiator, i.e., these can be employed as a thermosetting resin.
To obtain the hard coat layer, hard polyfunctional monomer such as pentaerythritol tri(meth)acrylate, pentaerythritol tetra(meth)acrylate, and dipentaerythritol hexa(meth)acrylate, is preferably used in a main component.
Photopolymerization initiators can be optionally selected depending upon the properties of the ultraviolet curable resin used. Examples of the photopolymerization initiators include acetophenone type initiators such as 2-hidroxy-2-methyl-1-phenylpropane-1-on, 1-hydroxycyclohexylphenylketone and 2-methyl-1-[4-(methylthio)phenyl]-2-morphorino-propane-1-on; benzoin type initiators such as benzylmethylketal; benzophenone type initiators such as benzophenone, 4-phenylbenzophenone and hydroxybenzophenone; thioxanthone type initiators such as isopropylthioxanthone and 2,4-diethythioxanthone. Further, as special type, there can be mentioned methylphenylglyoxylate. Especially preferred are 2-hidroxy-2-methyl-1-phenylpropane-1-on, 1-hydroxycyclohexylphenylketone, 2-methyl-1-[4-(methylthio)phenyl]-2-morphorinopropane-1-on and benzophenone. These photopolymerization initiators can be employed together with one or more kinds of a conventional photopolymerization promoter such as a benzoic acid type compound (e.g., 4-dimethylaminobenzoic acid) or a tertiary amine compound by mixing with the promoter in optional ratio. Only the initiator can be employed singly or in combination of two or more kinds. Especially, 1-hydroxycyclohexylphenylketone (Irgercure 184, available from Chiba-Specialty Chemicals) is preferred.
The initiator is preferably contained in the resin composition in the range of 0.1 to 10% by weight, particularly 0.1 to 5% by weight based on the resin composition.
The hard coat layer may further contain an ultraviolet absorber, an aging resistant agent, a dye, and a processing auxiliary agent for paint in a small amount. Particularly the layer preferably contains the ultraviolet absorber (e.g., benzotriazole ultraviolet absorber, or benzophenone ultraviolet absorber), whereby yellowing of the optical filter can be efficiently prevented. The amount generally is in the range of 0.1 to 10% by weight, preferably 0.1 to 5% by weight based on the resin composition.
The hard coat layer preferably has lower reflective index than that of the transparent substrate, and the use of the ultraviolet curable resin generally brings about easily the lower reflective index. Hence, as the transparent substrate, materials having high reflective index such as PET are preferably used. Therefore the hard coat layer preferably has reflective index of not more than 1.60. The thickness is mentioned above.

The high reflective index layer is preferably a layer (cured layer) in which conductive metal oxide particles (inorganic compound) such as ITO, ATO, Sb₂O₃, SbO₂, In₂O₃, SnO₂, ZnO, Al-doped ZnO, TiO₂ are dispersed in polymer (preferably ultraviolet curable resin). The conductive metal oxide particle generally has mean particle size of 10 to 1000nm, preferably 10 to 50nm. Especially ITO (especially mean particle size of 10 to 50nm) is preferred. The high reflective index layer preferably has refractive index not less than 1.64. The thickness generally is in the range of 10 to 500nm, preferably 20 to 200nm.
In case the high reflective index layer has conductive layer, the minimum reflectivity of the surface of the antireflection layer can be reduced to not more than 1.5% by increasing the reflective index of the high reflective index layer to not less than 1.64. Further the minimum reflectivity of the surface of the antireflection layer can be reduced to not more than 1.0% by preferably increasing the reflective index of the high reflective index layer as not less than 1.69, especially 1.69 to 1.82.
The low reflective index layer preferably a layer (cured layer) in which particles of silica or fluorine resin (preferably hollow silica) are dispersed in polymer (preferably ultraviolet curable resin). The low reflective index layer contains preferably 10 to 40 % by weight, especially 10 to 30% by weight of the particles. The low reflective index layer preferably has refractive index of 1.45 to 1.51. The refractive index of more than 1.51 brings about reduction of antireflection property of the antireflection layer. The thickness generally is in the range of 10 to 500nm, preferably 20 to 200nm.
The hollow silica preferably has mean particle size of 10 to 100nm, especially 10 to 50nm, and specific gravity 0.5 to 1.0, especially 0.8 to 0.9.
The hard coat layer preferably has visible light transmission of not less than 85%. Also, the low and high reflective index layers preferably have visible light transmission of not less than 85%.
In case the antireflection layer is composed of the hard coat layer and the above-mentioned two layers, for example, the hard coat layer has a thickness of 2 to 20µm, the high reflective index layer has a thickness of 75 to 90nm, and the low reflective index layer has a thickness of 85 to 110nm.

The provision of each of the antireflection layer can be carried out, for example, by mixing polymer (preferably ultraviolet curable resin) with if desired the above-mentioned particles, and applying the resultant coating liquid onto a transparent substrate, and then drying and exposed to ultraviolet rays. The layers may be applied and exposing to UV rays, respectively, or all the layers may be applied and then exposing to UV rays at one time.
The application can be carried out, for example, by applying a coating liquid (solution) of ultraviolet curable resin including acrylic monomers in a solvent such as toluene by means of gravure coater, and drying, and then exposing to UV rays to be cured. This wet-coating method enables high-speed, uniform and cheap film formation. After the coating, for example, the coated layer is exposed to UV rays to be cured whereby the effects of improved adhesion and enhanced hardness of the layer can be obtained. The conductive layer can be formed in the same manner.
In the UV- rays curing, it is possible to adopt, as light source used, various sources generating light in the wavelength range of ultraviolet to visible rays. Examples of the sources include super-high-pressure, high-pressure and low-pressure mercury lamps, a chemical lamp, a xenon lamp, a halogen lamp, a mercury halogen lamp, a carbon arc lamp, and an incandescent electric lamp, and laser beam. The exposed time is generally in the range of a few seconds to a few minutes, depending upon kinds of the lamp and strength of light. To promote the curing, the laminate may be heated beforehand for 40 to 120°C, and then the heated laminate may be exposed to ultraviolet rays.
As mentioned above, the anti-glare layer is preferably formed instead of the hard coat layer, which is apt to bring about enhanced antireflection effect. The anti-glare layer is preferably obtained, for example, by applying a coating liquid (ink medium) of pigments (e.g., carbon black, black iron oxide) or a coating liquid (solution) of transparent filler such as polymer particles (e.g., acrylic beads) preferably having mean particle size of 1 to 10m dispersed in binder and drying, or by forming an anti-glare layer of metal sulfate by blackening treatment such as sulfiding treatment of a metal layer. Or, the anti-glare layer is preferably obtained by applying a coating liquid (solution) of ultraviolet curable resin including the transparent filler such as polymer particles (e.g., acrylic beads) in materials for forming hard coat layer, and cured to have hard coat function. The anti-glare layer preferably has thickness of 0.01 to 1µm.

The near-infrared absorption layer is generally obtained by forming a layer containing dye on a surface of the transparent substrate. The near-infrared absorption layer is prepared, for example, by applying a coating liquid comprising the dye and ultraviolet- or electron-beam- curable resin or thermosetting resin containing binder resin, if desired drying and curing. Otherwise, the near-infrared absorption layer can be also prepared by applying a coating liquid containing dye and binder resin, and only drying. When the near-infrared absorption layer is used as a film, it is generally a near-infrared cut film, such as dye-containing film. The dye generally has absorption maximum in wavelength of 800 to 1,200nm, and its examples include phthalocyanine dyes, metal complexes dyes, nickel dithioren complexes dyes, cyanine dyes, squalirium dyes, polymethine dyes, azomethine dyes, azo dyes, polyazo dyes, diimmonium dyes, aminium dyes, anthraquinone dyes. Preferred are cyanine dyes, squalirium dyes. These dyes can be employed singly or in combination. Examples of the binder resin include thermoplastic resin such as acrylic resin.
In the invention, a neon-emission absorption function may be given to the near-infrared absorption layer such that the near-infrared absorption layer has function for adjusting color hue. For this purpose, although a neon-emission absorption layer may be provided, the near-infrared absorption layer may contain a neon-emission selective absorption dye.
Examples of the neon-emission selective absorption dyes include cyanine dyes, squalirium dyes, anthraquinone dyes, phthalocyanine dyes, polymethine dyes, polyazo dyes, azulenium dyes, diphenylmethane dyes, triphenylmethane dyes. The neon-emission selective absorption dyes are required to have neon-emission selective absorption function at wavelength of approx. 585nm and small absorption in a wavelength range of visible light except the wavelength. Hence, the dyes preferably have absorption maximum wavelength of 575 to 595nm, and half bandwidth of absorption spectrum of 40nm or less.
In case a plurality of the absorption dyes, which include a dye for absorbing near-infrared light or a dye for absorbing neon emission light, are used in combination, if there are difficulties in terms of solubility of dyes, if there are undesirable reactions among mixed dyes, and if deterioration of thermal resistance or moisture resistance occurs, it is not necessary for all the near-infrared absorption dyes to be contained in the same layer, and the near-infrared absorption dyes may be contained in different layers in such a case.
Further, coloring materials, ultraviolet absorbers, and antioxidants may be added so long as those materials do not adversely affect the optical properties of the filter.
The optical filter of the invention generally has, as the near-infrared absorption properties, the transmittance of light in a wavelength range of 850 to 1000 nm of 20% or lower, of preferably, 15% or lower. The optical filter of the invention preferably has, as the selective absorption properties of the optical filter, the transmittance of light at a wavelength of 585 nm of 50% or lower. In the former properties, a transmittance of light existing in the wavelength range can be reduced, the wavelength range being thought to be a cause of malfunction of remote control systems in peripheral devices. In the latter property, since orange light having peak wavelength in the range of 575 to 595 nm deteriorates color reproductivity, the wavelength of orange light can be absorbed so as to make red light more intrinsic and as a result, reproducibility of colors can be improved.
The near-infrared absorption layer generally has thickness of 0.5 to 50µm.

Though the conductive metal layer exposed in the side edge may be per se used as the electrode part, a conductive tape may be attached to the exposed area of the conductive metal layer to be used as an electrode part.
In case a conductive adhesive tape is attached onto the exposed area of the conductive metal layer at side edge, as the conductive adhesion tape, a tape having a metal foil and an adhesion layer having electrically conductive particle dispersed in the layer provided on one side of the foil can be used. For forming the adhesion layer, adhesives such as acrylic adhesive, rubber adhesive and silicone adhesive, or epoxy resin or phenol resin containing hardening agent can be used.
As the electrically conductive particle to be dispersed in the adhesion layer, any materials showing good electrical conductivity can be used. Examples include metallic powder such as copper, silver, nickel powder, and resin or ceramic powder coated with the metal. Further the shape of the electrically conductive particle is also not restricted. Optional shape such as scale, arborization, grain, and pellet can be adopted.
The electrically conductive particle is generally used in the amount of 0.1 to 15% by volume based on polymer of the adhesion layer, and the mean particle size preferably is in the range of 0.1 to 100µm. The use of the particle specified in the used amount and particle size brings about prevention of aggregation of the conductive particles to provide good conductivity.
As the metallic foil as substrate of the conductive adhesive tape, a foil of metal such as copper, silver, nickel, aluminum, stainless can be used. The thickness generally is in the range of 1 to 100µm.
The adhesion layer can be easily formed by applying a mixture of the adhesive and the conductive particle in a predetermined ratio onto the metal foil by means of roll coater, die coater, knife coater, mica bar coater, flow coater, spray coater.
The thickness of the adhesion layer generally is in the range of 5 to 100µm.
Instead of the conductive adhesion tape, an adhesive made of materials constituting the adhesion layer mentioned above may be applied to the exposed area of the conductive metal layer, and a conductive tape (metal foil) may be attached to the adhesive.

The transparent adhesive layer of the invention is used to bond the optical filter of the invention to a display, and therefore any resin having adhesion function can be used as materials for forming the transparent adhesive layer. Examples of the materials include acrylic adhesives made of butyl acrylate and the like, rubber adhesives, TPE (thermoplastic elastomer) adhesives comprising as main component TPE such as SEBS (styrene/ethylene/butylene/styrene) and SBS (styrene/ butadiene/styrene).
The thickness of the transparent adhesive layer generally is in the range of 5 to 500µm, preferably in the range of 10 to 100µm. The optical filter can be generally attached to a glass plate of a display through the transparent adhesive layer.

In case of using two transparent substrates in the invention, examples of materials (adhesives) used in the adhesion of the films include ethylene/vinyl acetate copolymer, ethylene/methyl acrylate copolymer, acrylic resin (e.g., ethylene/(meth)acrylic acid copolymer, ethylene/ethyl (meth)acrylate copolymer, ethylene/methyl (meth)acrylate copolymer, metal-ion crosslinked ethylene/(meth)acrylic acid copolymer), and ethylene copolymers such as partially saponified ethylene/vinyl acetate copolymer, carboxylated ethylene/vinyl acetate copolymer, ethylene/(meth)acrylic acid/maleic anhydride copolymer, ethylene/vinyl acetate/ ethylene/(meth)acrylate copolymer. The (meth)acrylic acid means acrylic acid and methacrylic acid and the (meth)acrylate means acrylate and meth acrylate. Besides these polymers, there can be mentioned polyvinyl butyral (PVB) resin, epoxy resin, phenol resin, silicon resin, polyester resin, urethane resin, rubber adhesives, thermoplastic elastomer (TPE ) such as SEBS (styrene/ethylene/butylene/styrene) and SBS (styrene/ butadiene/styrene). The acrylic adhesives and epoxy resins are preferred because they show excellent adhesion.
The thickness of the above-mentioned adhesive layer generally is in the range of 10 to 50µm, preferably in the range of 20 to 30µm. The optical filter can be generally attached to a glass plate of a display through the adhesive layer under heating.
In case EVA (ethylene/vinyl acetate/ ethylene copolymer) is used as materials of the transparent adhesive layer, EVA generally has the content of vinyl acetate in an amount of 5 to 50 % by weight, especially 15 to 40 % by weight. When the content is less than 5 % by weight, the layer does not show satisfactory transparency. On the other hand, when the content is more than 50 % by weight, the layer extremely reduces in mechanical strength not to increase difficulty of film formation and occurrence of blocking between films.
As a crosslinking agent for thermo crosslinking, an organic peroxide is generally suitable. The organic peroxide is selected in the consideration of sheet-processing temperature, curing (bonding) temperature, and storage stability. Examples of the organic peroxide include 2,5-dimethylhexane-2,5-dihydroperoxide, 2,5-dimethyl-2,5-(t-butylperoxy)hexyne-3, di-t-butylperoxide, t-butylcumyl peroxide, 2,5-dimethyl-2,5-di(t-butylperoxy)hexane, dicumyl peroxide, α,α'-bis(t-butylperoxyisopropyl)benzene, n-butyl-4,4-bis(t-butylperoxy)valerate, 2,2-bis(t-butylperoxy)butane, 1,1-bis(t-butylperoxy)cyclohexane, 1,1-bis(t-butylperoxy)-3,3,5-trimethylcyclohexane, t-butylperoxybenzoate, benzoyl peroxide, t-butylperoxyacetate, methyl ethyl ketone peroxide, 2,5-dimethylhexyl-2,5-bisperoxybenzoate, butyl hydroperoxide, p-menthane hydroperoxide, p-chlorobenzoyl peroxide, t-butylperoxyisobutylate, hydroxyheptyl peroxide and chlorohexanone peroxide. The organic peroxide can be used singly, or in combination of two or more kinds. The content of the organic peroxide is generally used in an amount of not more than 5 parts by weigh, preferably 0.5 to 5 parts by weight based on 100 parts by weight of EVA.
The organic peroxide is generally kneaded with EVA by means of an extruder or roll mill. However it may be solved in an organic solvent, plasticizer, vinyl monomer and added to an EVA film by means of impregnation method.
The EVA may contain acryloyl group-containing compounds, methacryloyl group-containing compounds, allyl group-containing compounds for improvement of various properties of EVA (e.g., mechanical strength, optical characteristics, adhesive property, weather resistance, whitening resistance, rate of crosslinking).
The EVA adhesive layer of the invention can further contain a small amount of silane coupling agent, ultraviolet absorbing agent, infrared absorbing agent, age stabilizer (antioxidant), paint processing aid and colorant. If appropriate, filler such as carbon black, hydrophobic silica or calcium carbonate may be contained.
The adhesive layer for adhesion can be obtained, for example, by mixing EVA with the above-mentioned additives and kneaded by means of extruder or roll, and then forming the sheet having the predetermined shape by film formation method using calendar, roll, T-die extrusion or blowing.
A protective layer may be provided on the antireflection layer. The protective layer is preferably formed in the same manner as that of the hard coat layer.

Materials for the release sheet provided on the transparent adhesive layer is generally transparent polymers having glass transition temperature of not less than 50°C. Examples of the materials include polyester resin (e.g., polyethylene terephthalate, polycyclohexylene terephthalate, polyethylene naphthalate), polyamide (e.g., nylon 46, modified nylon 6T, nylon MXD6, polyphthalamide), ketone resin (e.g., polyphenylene sulfide, polythioether sulfone), sulfone resin (e.g., polysulfone, polyether sulfone), polyether nitrile, polyarylate, polyether imide, polyamideimide, polycarbonate, polymethyl methacrylate, triacetylcellulose, polystyrene or polyvinyl chloride. Of these resins, polycarbonate, polymethyl methacrylate, polyvinyl chloride, polystyrene and polyethylene terephthalate can be preferably employed. The thickness is generally in the range of 10 to 200µm, especially in the range of 30 to 100µm.

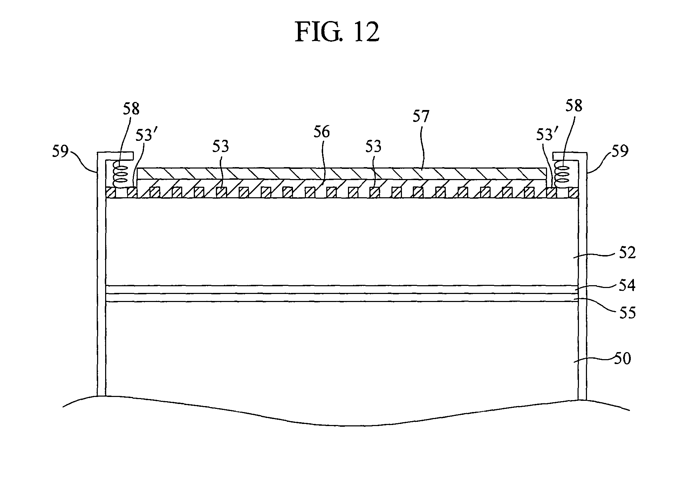

A schematic section view showing an example of the condition that the optical filter is attached onto an image display surface of a plasma display panel as one kind of display is shown in Fig. 12. The optical filter is attached onto the image display surface of the plasma display panel 50 through the transparent adhesive layer 55. In more detail, the optical filter is provided on the image display surface of the plasma display panel 50, the optical filter having a structure that a mesh-shaped conductive metal layer 53, a hard coat layer 56 and an antireflection layer 57 such as a low refractive index layer are provided on one surface of a transparent substrate 52 in this order, and a near-infrared absorption layer 54 and a transparent adhesive layer 55 are provided on the other surface of the transparent substrate 52 in this order. Further, a mesh-shaped conductive metal layer 53' is exposed in an edge area (side edge area) of the filter. The exposed mesh-shaped conductive metal layer 53' is in contact with a metallic cover 59 provided on a periphery of the plasma display panel 50 through a shield finger (leaf-spring shaped metal part) 58. A conductive gasket may be used instead of the leaf-spring shaped metal part. Hence, conduction between the optical filter and the metallic cover 59 can be attained to bring about grounded condition. The metallic cover 59 may be metal rack or frame. As apparent from Fig. 11, the mesh-shaped conductive metal layer 53 is directed to viewing audience. The metallic cover 59 covers the range of from the farthest edge of the conductive metal layer 53 to 2-20mm. Otherwise, the shape of the metallic cover 59 is altered whereby the metallic cover 59 may be brought directly in contact with the conductive metal layer 53'.
In the PDP of the invention, a plastic film is generally used as the transparent substrate, and therefore the optical filter is directly attached onto a surface of a glass plate of the PDP whereby PDP itself can be reduced in weight, thickness and cost, especially in case of using one transparent substrate. Further, compared with PDP having a front plate of a transparent molded body in front of the PDP, PDP provided with the optical filter of the invention enables the removal of an air layer between PDP and a filter for PDP can be removed and hence resolves the increase of visible-rays reflectivity caused by the interface reflection and the occurrence of the double reflection. Thereby PDP of the invention can be improved in visibility.
Thus, the display provided with the optical filter of the invention not only enables easy earth ground, but also brings about excellent antireflection property and antistatic property, and further almost suppression of radiation of dangerous electromagnetic wave.

### EXAMPLE

The invention is illustrated in detail using the following Examples and Comparative Examples. The invention is not restricted by the following Examples.

### [Example 1]

### <Preparation of optical filter for display provided with electrode part>

### (1) Formation of mesh-shaped conductive metal layer

On an adhesion layer (polyester urethane: thickness of 20nm) of a continuous polyethylene terephthalate (PET) film having thickness of 100µm (width of 600mm, length of 100m) having the adhesion layer thereon, a polyvinyl alcohol aqueous solution (20%) was printed in dot pattern. A shape of each of the dots was square having a side of 234µm, a distance between the dots was 20µm, and the arrangement of the dots was in the form of square grid (lattice). The printed thickness was approx. 5µm after drying.
On the PET film having dot pattern, copper was vacuum-deposited to form a copper layer having mean thickness of 4µm. Subsequently, the PET film having dot pattern and copper layer was immersed in room-temperature water and the dots were dissolved and removed by rubbing with sponge, and then was rinsed with water, dried to form a mesh-shaped conductive metal layer on the whole surface of the PET film (see Fig. 1(1)).
The conductive metal layer on the PET film showed pattern of square grid (mesh) precisely corresponding to negative pattern of the dot pattern. The line width of the mesh is 20µm, and the opening ratio was 77%. Further mean thickness of the conductive layer (copper layer) was 4µm.

### (2) Formation of hard coat layer

The following composition:

| | |
|---|---|
| Dipentaerythritol hexaacrylate (DPHA) | 80 weight parts |
| ITO (Mean particle size: 150nm) | 20 weight parts |
| Methyl ethyl ketone | 100 weight parts |
| Toluene | 100 weight parts |
| Irgacure 184 | |
| (Available from Ciba specialty chemicals) | 4 weight parts |

was mixed to form a coating liquid, which was applied onto the whole surface of the mesh-shaped conductive metal layer with a bar coater (see Fig. 1(2)), and cured by UV irradiation. Hence, a hard coat layer having thickness of 5µm (refractive index: 1.52) was formed on the mesh-shaped conductive metal layer.

### (3) Formation of low refractive index layer

The following composition:

| | |
|---|---|
| Opster JN-7212 (Available from JSR) | 100 weight parts |
| Methyl ethyl ketone | 117 weight parts |
| Methyl isobutyl ketone | 117 weight parts |

was mixed to form a coating liquid, which was applied onto the surface of the hard coat layer with a bar coater, and dried in an oven at 80°C for five minutes, and then cured by UV irradiation. Hence, a low refractive index layer having thickness of 90nm (refractive index: 1.42) was formed on the hard coat layer.

### (4) Formation of near-infrared absorption layer (having color hue adjusting function)

The following composition:

| | |
|---|---|
| Polymethyl methacrylate | 30 weight parts |
| TAP-2 | |
| (Available from Yamada Chemical Co., Ltd.) | 0.4 weight part |
| Plast Red 8330 | |
| (Available from Arimoto Chemical Co., Ltd.) | 0.1 weight part |
| CIR-1085 | |
| (Available from Japan Carlit Co., Ltd.) | 1.3 weight part |
| IR-10A | |
| (Available from Nippon Syokubai Co., Ltd.) | 0.6 weight part |
| Methyl ethyl ketone | 152 weight parts |
| Methyl isobutyl ketone | 18 weight parts |

was mixed to form a coating liquid, which was applied onto the whole reverse side of the PET film with a bar coater, and dried in an oven at 80°C for five minutes. Hence, a near-infrared absorption layer provided with color hue adjusting function having thickness of 5µm was formed on the reverse side of PET film.

### (5) Formation of transparent adhesive layer

The following composition:

| | |
|---|---|
| SK Dyne 1811 L (Available from | |
| Soken Chemical & Engineering Co., Ltd.) | 100 weight parts |
| Hardener L-45 (Available from | |
| Soken Chemical & Engineering Co., Ltd.) | 0.45 weight part |
| Toluene | 15 weight parts |
| Ethyl acetate | 4 weight parts |

was mixed to form a coating liquid, which was applied onto the near-infrared absorption layer with a bar coater, and dried in an oven at 80°C for five minutes. Hence, a transparent adhesive layer having thickness of 25 µm was formed on the near-infrared absorption layer.
Subsequently, the both side edges of the low refractive index layer of the resultant laminate was intermittently (interval of on/off: 0.001 second) irradiated with laser using a CO₂ laser processing machine fixed on each of the both side edges under the conditions of pulse of 300 microseconds, wavelength of 10.6µm, output of 50W, focused diameter (beam diameter) of 0.6mm at focus position of the low refractive index layer with the resultant laminate being moved at 100mm/sec., by means of roll-on-roll system.
On the both side edges of the low refractive index layer, three rows of intermittent band-shaped areas of island-shaped areas are formed in the form of zigzag, whereby an exposed area of conductive layer 13' (intermittent band-shaped region: width of 5mm; a structure shown in Fig. 5(3)) and an edge-area low refractive index layer outside the exposed area of conductive layer 13' (width: 0.5mm) were formed.
The number of the island-shaped (conductive metal layer) areas was 121/cm² in the area of the intermittent band-shaped region, and the area ratio of the island-shaped areas was 35% based on the area of the intermittent band-shaped region. The exposed area of conductive layer 13' was made up of the island-shaped (conductive metal layer) areas, each of which had the following size: maximum radius of 0.9mm, and D1, D2 and D3 of 2.1mm {= (maximum radius of island-shaped area 33") × 2 + 0.3}.
Subsequently, the laminate under running was stopped, the low refractive index layer of the resultant laminate was intermittently (interval of on/off: 0.001 second) irradiated with a laser by using the same CO₂ laser processing machine as above under the conditions of output of 50W, moving speed of 100mm/sec., focused diameter of 0.6mm at focus position of the low refractive index layer, whereby an exposed area of conductive layer was formed in the width direction in the same manner as above. Thereafter the laminate was cut to prepare an optical filter (filter size: 60mm × 400mm).
Thus, an optical filter for display provided with electrode part in its periphery was obtained.

### [Estimation of optical filter]

### (1) Conductive property

A resistance meter (Trade name: Milliohm high tester; Hioki E.E. Corporation) was connected to the electrode parts (opposite two electrode parts) of the optical filter to measure resistance value.
The resistance value was 150 mΩ.

### (2) Appearance

The exposed area of conductive layer of the optical filter is subjected to peeling test of cellophane tape, and thereafter the tested area is observed.
Damage such as peeling was not found in the test area, which showed good appearance.
Further, in case the PDP filter obtained in Example 1 is attached onto PDP, the resultant PDP provided with the filter favorably compare with conventional PDP in performances such as transparency and electromagnetic-wave shielding property. Furthermore, the PDP filters can be easily attached to PDP to enhance productivity of PDP.

### [Industrial applicability]

The optical filter of the invention provided with island-shaped conductive metal layer areas (electrode part) having the specific density (number) and the specific area ratio of the island-shaped areas has electrode part (earth electrode) that can be easily grounded, and simultaneously is almost free of defect, and further has excellent productivity. Thus the optical filter for display of the invention is capable of adding various functions such as antireflection, near-infrared shielding and electromagnetic wave shielding to various displays such as plasma display panel (PDP), cathode-ray-tube (CRT) display, liquid crystal display, organic EL (electroluminescence) display, field emission display (FED) including surface-conduction electron-emitter display (SED), and shows high productivity.

## Claims

1. An optical filter for display provided with an electrode part comprising a transparent substrate, a conductive metal layer provided on a surface of the transparent substrate, and a functional layer provided on a surface of the conductive metal layer, the electrode part consisting of the conductive metal layer,
wherein the conductive metal layer is exposed in a large number of island-shaped areas at a side edge of the functional layer or in a vicinity of the side edge, and
the number of the island-shaped areas is 25 to 250/cm² based on an intermittent band-shaped region and an area ratio of the island-shaped areas is 2 to 50% based on the intermittent band-shaped region, the intermittent band-shaped region being defined by a band-shaped area having a perpendicular width between the most inside point and the most outside point of the island-shaped areas.

2. An optical filter for display as defined in claim 1, wherein the area ratio of the island-shaped areas is 15 to 50%.

3. An optical filter for display as defined in claim 1 or 2, wherein the intermittent band-shaped region consists of plural rows, each of the rows being formed from a large number of island-shaped areas arranged in a line.

4. An optical filter for display as defined in any of claims 1 to 3, wherein the conductive metal layer is a mesh-shaped conductive metal layer.

5. An optical filter for display as defined in any of claims 1 to 4, wherein the functional layer is a hard coat layer.

6. An optical filter for display as defined in any of claims 1 to 5, wherein other functional layer(s) is provided on a side having no conductive metal layer of the transparent substrate.

7. An optical filter for display as defined in any of claims 1 to 6, which is attached to a glass plate.

8. A process for the preparation of an optical filter for display provided with an electrode part consisting of a conductive metal layer,
which comprises a step of intermittently irradiating with a laser a side edge of a functional layer of a laminate or in a vicinity of the side edge to remove the irradiated areas of the functional layer whereby the conductive metal layer is exposed in a large number of island-shaped areas, the laminate comprising a transparent substrate, the conductive metal layer provided on a whole surface of the transparent substrate, and the functional layer provided on a whole surface of the conductive metal layer,
the number of the island-shaped areas being 25 to 250/cm² in an intermittent band-shaped region, an area ratio of the island-shaped areas being 2 to 50% based on the intermittent band-shaped region, and the intermittent band-shaped region being defined by a band-shaped area having a perpendicular width between the most inside point and the most outside point of the island-shaped areas.

9. A process for the preparation of an optical filter for display as defined in claim 8, wherein the area ratio of the island-shaped areas is 15 to 50%.

10. A process for the preparation of an optical filter for display as defined in claim 8 or 9, wherein a diameter of focused beam of the laser irradiating the functional layer is 0.4 to 1.0mm.

11. A process for the preparation of an optical filter for display as defined in any of claims 8 to 10, wherein a wavelength of the laser is 0.2 to 30µm.

12. A process for the preparation of an optical filter for display as defined in any of claims 8 to 11, wherein the laser is a pulse laser.

13. A display panel provided with the optical filter for display as defined in any of claims 1 to 7.

14. A plasma display panel provided with the optical filter for display as defined in any of claims 1 to 7.
